(19) Europäisches Patentamt / European Patent Office / Office européen des brevets

(11) **EP 3 729 299 B1**

(12) **FASCICULE DE BREVET EUROPEEN**

(45) Date de publication et mention de la délivrance du brevet:
**22.05.2024 Bulletin 2024/21**

(21) Numéro de dépôt: **18814612.0**

(22) Date de dépôt: **10.12.2018**

(51) Classification Internationale des Brevets (IPC):
**G06F 17/17** *(2006.01)*    **H03H 17/02** *(2006.01)*
**H03H 17/06** *(2006.01)*

(52) Classification Coopérative des Brevets (CPC):
**G06F 17/17; H03H 17/0211; H03H 17/0294;**
**H03H 17/0621;** H03H 2017/0214

(86) Numéro de dépôt international:
**PCT/EP2018/084244**

(87) Numéro de publication internationale:
**WO 2019/121122 (27.06.2019 Gazette 2019/26)**

(54) **FILTRE INTERPOLATEUR NUMERIQUE, DISPOSITIF DE CHANGEMENT DE RYTHME ET EQUIPEMENT DE RECEPTION CORRESPONDANTS**

DIGITALER INTERPOLATIONSFILTER, ENTSPRECHENDE RHYTHMUSWECHSELVORRICHTUNG UND EMPFANGSVORRICHTUNG

DIGITAL INTERPOLATION FILTER, CORRESPONDING RHYTHM CHANGING DEVICE AND RECEIVING EQUIPMENT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.12.2017 FR 1762632**

(43) Date de publication de la demande:
**28.10.2020 Bulletin 2020/44**

(73) Titulaire: **B-Com**
**35510 Cesson-Sevigne (FR)**

(72) Inventeurs:
• **PAQUELET, Stéphane**
**35700 Rennes (FR)**
• **ZEINEDDINE, Ali**
**35450 Dourdain (FR)**

(74) Mandataire: **Vidon Brevets & Stratégie**
**16B, rue de Jouanet**
**BP 90333**
**35703 Rennes Cedex 7 (FR)**

(56) Documents cités:
• **L.F.O. CHAMON ET AL: "Efficient filtering structure for spline interpolation and decimation", ELECTRONICS LETTERS, vol. 52, no. 1, 8 janvier 2016 (2016-01-08), pages 39-41, XP055505846, GB ISSN: 0013-5194, DOI: 10.1049/el.2015.1957 cité dans la demande**
• **M.A. Al-Alaoui: "Using fractional delay to control the magnitudes and phases of integrators and differentiators", , 25 juin 2007 (2007-06-25), pages 107-119, XP055507055, Extrait de l'Internet: URL:https://feaweb.aub.edu.lb/research/dsaf/Publications/Alaoui_Fractional.pdf [extrait le 2018-09-13]**
• **Vesa Lehtinen ET AL: "Structures for Interpolation, Decimation, and Nonuniform Sampling Based on Newton's Interpolation Formula", , 30 janvier 2010 (2010-01-30), XP055507059, Extrait de l'Internet: URL:https://hal.archives-ouvertes.fr/hal-00451769/document [extrait le 2018-09-13]**

- ZEINEDDINE A ET AL: "RECONFIGURABLE NEWTON STRUCTURE FOR SAMPLE RATE CONVERSION", 2018 IEEE GLOBAL CONFERENCE ON SIGNAL AND INFORMATION PROCESSING (GLOBALSIP), IEEE, 26 novembre 2018 (2018-11-26), pages 271-275, XP033520618, DOI: 10.1109/GLOBALSIP.2018.8646354 [extrait le 2019-02-20]
- ZEINEDDINE ALI ET AL: "Variable Fractional Delay Filter: A Novel Architecture Based on Hermite Interpolation", 2018 25TH INTERNATIONAL CONFERENCE ON TELECOMMUNICATIONS (ICT), IEEE, 26 juin 2018 (2018-06-26), pages 93-97, XP033400108, DOI: 10.1109/ICT.2018.8464948 [extrait le 2018-09-13]

**Description**

## 1 DOMAINE TECHNIQUE

Le domaine de l'invention est celui de l'interpolation d'échantillons numériques.

Plus précisément, l'invention concerne un filtre interpolateur numérique présentant une réponse fréquentielle paramétrable.

Un tel filtre est particulièrement utile pour le changement de rythme d'échantillonnage de signaux dont l'environnement fréquentiel est variable. Ainsi, l'invention a de nombreuses applications, notamment, mais non exclusivement, dans le domaine de la réception de signaux radiofréquence ou du traitement de signaux audiofréquence.

## 2 ARRIERE-PLAN TECHNOLOGIQUE

Les filtres interpolateurs sont des filtres numériques permettant de calculer la valeur d'un signal à des instants où des échantillons numériques du signal en question ne sont pas disponibles.

Par exemple, un filtre interpolateur a comme entrée N échantillons disponibles du signal à interpoler, ainsi qu'un paramètre représentatif des instants d'échantillonnage auxquels des échantillons du signal doivent être calculés. Le filtre délivre alors une approximation de la valeur du signal aux instants désirés tels que définis via le paramètre en question.

Classiquement, les filtres utilisés pour réaliser une telle fonction sont basés sur une interpolation polynomiale des échantillons d'entrée.

Une structure couramment utilisée pour implémenter une telle interpolation polynomiale est la structure de Farrow décrite dans l'article de Farrow, C. W. « A continuously variable digital delay element Circuits and Systems », IEEE International Symposium on, 1988, 2641-2645 vol.3. En effet, la structure de Farrow permet d'implémenter une interpolation polynomiale quelle que soit la nature des polynômes considérés, ce qui explique en partie son succès.

Dans ce cas, le paramètre représentatif des instants d'échantillonnage du signal de sortie du filtre définit en général un retard (e.g. une fraction de la période d'échantillonnage) par rapport aux instants d'échantillonnage des échantillons disponibles en entrée du filtre. Si besoin, un tel retard peut être rendu variable et reprogrammable à la volée entre deux échantillons afin de permettre également un changement de la fréquence d'échantillonnage. En pratique, le retard en question peut a priori être arbitraire, seules les contraintes d'implémentation matérielles venant limiter la granularité de ce paramètre.

Cependant, une telle structure de Farrow présente une complexité calculatoire non négligeable. C'est pourquoi des structures dérivées de la structure de Farrow ont été proposées afin d'en réduire la complexité calculatoire.

À titre d'exemple, on peut citer la structure de Farrow symétrisée décrite dans l'article de Valimaki, V. « A new filter implémentation strategy for Lagrange interpolation, » Circuits and Systems, 1995. ISCAS '95., 1995 IEEE International Symposium on, Seattle, WA, 1995, pp. 361-364 vol.1. Une telle structure conserve l'avantage de s'appliquer à tout type de polynômes, mais ne procure que peu de gain d'implémentation. Notamment la complexité reste proportionnelle au carré de l'ordre de l'interpolation implémentée.

Alternativement, une structure dite de Newton, décrite dans l'article de Tassart, S., Depalle, P. « Fractional delay lines using Lagrange interpolation, » Proceedings of the 1996 International Computer Music Conférence, Hong Kong, April 1996, p341-343, dérivée de la structure de Farrow, permet d'obtenir une complexité calculatoire réduite, proportionnelle à l'ordre de l'interpolation implémentée. Cependant, une telle structure ne permet que des interpolations basées sur des polynômes de Lagrange.

Une telle structure a toutefois été généralisée en une structure dite quasi-Newton (ou « Newton-like » en anglais) décrite dans l'article de Lamb, D., Chamon, L., Nascimento, V. « Efficient filtering structure for spline interpolation and decimation, » Electronics Letters, IET, 2015, 52, p39-41. Une telle structure quasi-Newton permet de conserver une complexité calculatoire proportionnelle à l'ordre de l'interpolation implémentée, mais pour une interpolation basée sur des polynômes de type Spline.

Cependant, quelle que soit la structure de filtre considérée, une fois l'ordre choisi ainsi que, le cas échéant, la nature des polynômes utilisés pour l'interpolation, le gabarit de filtrage se trouve figé.

Or, certaines applications nécessitant un tel changement de rythme gagneraient à avoir une réponse fréquentielle du filtre interpolateur en question qui soit adaptable. Par exemple, dans le cadre de l'implémentation d'un récepteur multimodes, l'environnement du signal à recevoir (en termes de signaux interférents, etc.) dépend du standard en question.

La solution actuelle consiste à reconfigurer entièrement la réponse du filtre interpolateur, notamment en termes de la nature des polynômes interpolateurs, pour l'adapter au nouveau standard du signal de réception lors d'un basculement d'un standard à l'autre. Ceci nécessite dans ce cas d'utiliser une structure de filtre permettant d'implémenter tout type d'interpolation polynômiale. Comme discuté ci-dessus, seule la structure de Farrow, symétrisée ou non, offre une telle souplesse. Cependant, une telle structure est complexe en termes de charge de calcul. Par ailleurs, une telle approche nécessite de calculer et/ou de stocker un jeu complet de paramètres du filtre pour chaque configuration de réception à adresser. Cela limite en pratique ce genre d'approche à quelques configurations de réception.

Il existe ainsi un besoin pour un filtre interpolateur présentant une réponse fréquentielle et temporelle paramétrable en fonction d'un nombre réduit de paramètres.

Il existe également un besoin pour qu'un tel filtre soit simple en termes d'implémentation matérielle.

## 3 RESUME

Dans un mode de réalisation de l'invention, il est proposé un dispositif de filtrage interpolateur numérique à retard fractionnaire d'un signal x(t) délivrant une série d'échantillons de sortie approximant un signal $x(t)$ à des instants d'échantillonnage de la forme $(n + d)T_s$ sur la base d'une série d'échantillons d'entrée du signal $x(t)$ pris à des instants d'échantillonnage de la forme $nT_s$, avec $n$ un entier, $T_s$ une période d'échantillonnage et $d$ un nombre réel définissant les instants fractionnaires d'échantillonnage. Un tel dispositif comprend

- une structure de Newton implémentant une première fonction de transfert $H_1^d(Z^{-1})$ représentant une interpolation polynomiale de type Lagrange des échantillons d'entrée implémentée selon une structure de Newton (telle que définie dans la partie 5 de la présente demande) ;
- une autre structure de Newton comprenant au moins ladite structure de Newton et implémentant une deuxième fonction de transfert $H_2^d(Z^{-1})$ représentant une autre interpolation polynomiale des échantillons ; et
- une fonction de transfert dudit filtre dans le domaine transformé en Z, $H_c^d(Z^{-1})$ s'exprimant comme une combinaison linéaire entre la première fonction de transfert et la deuxième fonction de transfert et étant fonction d'au moins un paramètre de combinaison c réel.

Ainsi, l'invention propose une solution nouvelle et inventive pour permettre une implémentation matérielle simple d'un filtre interpolateur présentant une réponse fréquentielle et temporelle paramétrable.

Pour ce faire, la structure matérielle implémentant la deuxième fonction de transfert comprend au moins la structure de Newton implémentant la première fonction de transfert. L'implémentation matérielle globale du filtre interpolateur tire ainsi parti de la synergie entre les deux structures et de l'efficacité de l'implémentation de la structure de Newton.

Par ailleurs, la combinaison linéaire permet de paramétrer de manière simple la réponse globale du filtre interpolateur entre les réponses des deux interpolations polynomiales en question.

Selon un mode de réalisation, la combinaison linéaire des première $H_1^d(Z^{-1})$ et deuxième $H_2^d(Z^{-1})$ fonctions de transfert s'exprime comme :

$$H_c^d(Z^{-1}) = H_1^d(Z^{-1}) + c\left(H_2^d(Z^{-1}) - H_1^d(Z^{-1})\right)$$

Selon un mode de réalisation, l'autre structure est une structure quasi-Newton (telle que définie dans la partie 5 de la présente demande).

Ainsi, l'implémentation matérielle de la deuxième fonction de transfert est également particulièrement efficace, et donc celle du filtre interpolateur global également.

Selon un mode de réalisation, l'autre interpolation polynomiale des échantillons d'entrée appartient au groupe comprenant :

- une interpolation polynomiale de type Spline des échantillons d'entrée ; et
- une interpolation polynomiale de type Hermite des échantillons d'entrée.

Ainsi, la structure quasi-Newton implémentant la deuxième fonction de transfert est obtenue directement et simplement en s'appuyant sur des méthodes de synthèse connues.

Selon un mode de réalisation :

- la première fonction de transfert $H_1^d(Z^{-1})$ est exprimée dans une base de polynômes en $Z^{-1}$ correspondant à une implémentation selon la structure de Newton ; et
- la deuxième fonction de transfert $H_2^d(Z^{-1})$ est exprimée au moins en partie dans la base de polynômes en $Z^{-1}$.

Ainsi, la première fonction de transfert (représentant une interpolation de Lagrange) et la deuxième fonction de transfert sont exprimées au moins en partie sur la même base transformée correspondant à une implémentation matérielle sous une forme particulièrement efficace (i.e. selon une structure de Newton).

De la sorte, la réutilisation de la structure de Newton implémentant la première fonction de transfert pour implémenter la deuxième fonction de transfert est simple et efficace.

Selon un mode de réalisation, le nombre réel $d$ est compris dans le segment $[-N/2; 1 - N/2[$, l'ordre de l'interpolation de type Lagrange étant égal à $N - 1$ avec $N$ un entier. La deuxième fonction de transfert $H_2^d(Z^{-1})$ s'exprime comme :

$$H_2^d(Z^{-1}) = \sum_{n=1}^{N} q_{n,1}(1 - Z^{-1})^{n-1} + \sum_{n=1}^{N}\sum_{m=2}^{N} q_{n,m} \left[ (1 - Z^{-1})^{n-1} \prod_{i=0}^{m-2}(d + i) \right]$$

avec $q_{n,m}$ des éléments d'une matrice $Q$ de N lignes et N colonnes, la matrice $Q$ s'exprimant comme un produit de matrices :

$$Q = \left(T_d^T\right)^{-1} P T_z^{-1}$$

avec :

- $T_d$ une matrice de N lignes et N colonnes transformant un vecteur $\vec{\mu} = [1, \mu, \mu^2, \dots, \mu^{N-1}]$ en un vecteur $\vec{d} = [1, d, d(d + 1), \dots, \prod_{i=0}^{N-2}(d + i)]$, avec $\mu = d + (N - 1)/2$ ;
- $T_z$ une matrice de N lignes et N colonnes transformant un vecteur $\vec{Z} = [1, z^{-1}, z^{-2}, \dots, z^{-(N-1)}]$ en un vecteur $\vec{\nabla Z} = [1, (1 - z^{-1}), (1 - z^{-1})^2, \dots, (1 - z^{-1})^{N-1}]$ ;
- $P$ une matrice de Farrow symétrique représentant l'autre interpolation,

la matrice $P$ ayant N lignes et N colonnes et représentant une fonction de transfert dans le domaine transformé en Z, $H_2^\mu(Z^{-1})$, s'exprimant comme :

$$H_2^\mu(Z^{-1}) = \sum_{j=1}^{N} \beta_j(\mu) z^{-(j-1)} = \sum_{j=1}^{N}\left(\sum_{i=1}^{N} p_{i,j}\,\mu^{i-1}\right) z^{-(j-1)}$$

avec $p_{i,j}$ un élément d'indice de ligne i et d'indice de colonne j de la matrice $P$, les N polynômes $\beta_j(\mu)$ vérifiant $\beta_j(\mu) = +\beta_{N-j+1}(\mu)$ ou $\beta_j(\mu) = -\beta_{N-j+1}(\mu)$.

Ainsi, une expression de la deuxième fonction de transfert sur la base transformée (i.e. à base de polynômes de la forme $(1 - Z^{-1})^k$, avec $k$ un entier) est facilement obtenue, quelle que soit la nature de l'interpolation polynomiale associée à la deuxième fonction de transfert. En effet, une matrice de Farrow symétrisée peut être obtenue pour une interpolation polynomiale quelle que soit la nature des polynômes en question.

Selon un mode de réalisation, la fonction de transfert $H_2^\mu(Z^{-1})$ représente une structure de Farrow symétrisée implémentant une interpolation polynomiale de type Spline ou de type Hermite des échantillons d'entrée.

Selon un mode de réalisation, la matrice $T_d$ s'exprime comme un produit de matrices $T_d = T_d^2 T_d^1$, avec $T_d^1$ et $T_d^2$ deux matrices de N lignes et N colonnes, au moins un élément, $T_d^1[i,j]$, d'indice de ligne i et d'indice de colonne j, de la matrice $T_d^1$, étant proportionnel à $\binom{i-1}{j-1}\left(-\frac{N-1}{2}\right)^{i-j}$, avec $\binom{i-1}{j-1}$ un coefficient binomial lu $j - 1$ parmi $i - 1$.

Au moins un élément, $T_d^2[i,j]$, d'indice de ligne i et d'indice de colonne j, de la matrice $Td$, étant proportionnel à un nombre de Stirling de première espèce $S_{j-1}^{(i-1)}$.

Selon un mode de réalisation, au moins un élément, $T_z[i,j]$, d'indice de ligne i et d'indice de colonne j, de la matrice $T_z$, est proportionnel à $\binom{i-1}{j-1}(-1)^{j+1}$ avec $\binom{i-1}{j-1}$ un coefficient binomial lu $j$ - 1 parmi $i$ - 1.

Ainsi, l'expression de la deuxième fonction de transfert sur la base transformée en question est obtenue quel que soit l'ordre de l'interpolation considérée.

Selon un mode de réalisation, le nombre réel $d$ ou/et le paramètre de combinaison c est/sont variable(s).

Ainsi, la réponse, fréquentielle et temporelle, du filtre interpolateur est reconfigurable.

Selon un mode de réalisation, le filtre comprenant une structure de Newton modifiée comprenant :

- la structure de Newton ; et
- au moins une boucle de retour additionnelle entre :

  - une sortie d'une ligne à retard de la structure de Newton ; et
  - une sortie de la structure de Newton ;

l'au moins une boucle de retour additionnelle comprenant au moins un bloc multiplieur. Un opérande du au moins un bloc multiplieur est proportionnel au paramètre de combinaison c.

Ainsi, le caractère adaptable de la réponse du filtre interpolateur est obtenu moyennant une modification minime de la structure de Newton, et donc moyennant un coût matériel réduit.

Selon un mode de réalisation, la structure de Newton modifiée implémente :

- la structure de Newton lorsque le paramètre de combinaison c vaut 0 ; et
- la structure quasi-Newton lorsque le paramètre de combinaison c vaut 1.

Selon un mode de réalisation, le paramètre de combinaison c est fixe et le filtre comprend une structure de Newton modifiée comprenant au moins en partie la structure de Newton.

Dans un mode de réalisation de l'invention, il est proposé un dispositif de changement de rythme d'échantillonnage comprenant au moins un dispositif de filtrage interpolateur numérique selon l'invention (selon l'un quelconque de ses modes de réalisation).

Ainsi, les caractéristiques et avantages de ce dispositif sont les mêmes que ceux du filtre interpolateur numérique décrit précédemment. Par conséquent, ils ne sont pas détaillés plus amplement.

Dans un mode de réalisation de l'invention, il est également proposé un équipement de réception d'un signal radiofréquence comprenant au moins un dispositif de changement de rythme d'échantillonnage comprenant au moins un filtre interpolateur numérique selon l'invention (selon l'un quelconque de ses modes de réalisation).

## 4 LISTE DES FIGURES

D'autres caractéristiques et avantages de l'invention apparaîtront à la lecture de la description suivante, donnée à titre d'exemple indicatif et non limitatif, et des dessins annexés, dans lesquels :

- la figure 1 illustre un filtre interpolateur connu implémentant une interpolation de Lagrange d'ordre trois implémentée selon une structure de Newton ;
- la figure 2 illustre un filtre interpolateur connu implémentant une interpolation de type Spline d'ordre trois implémentée selon une structure quasi-Newton ;
- les figures 3a et 3b illustrent un dispositif numérique à retard factionnaire comprenant un filtre interpolateur résultant d'une combinaison linéaire des filtres des figures 1 et 2 selon un mode de réalisation de l'invention ;
- la figure 4 illustre un filtre interpolateur connu implémentant une interpolation d'Hermite d'ordre trois implémentée selon une structure quasi-Newton ;
- les figures 5a et 5b illustrent un dispositif numérique à retard factionnaire comprenant un filtre interpolateur résultant d'une combinaison linéaire des filtres des figures 1 et 4 selon un mode de réalisation de l'invention ;
- la figure 5c illustre un dispositif numérique à retard factionnaire comprenant un filtre interpolateur résultant d'une combinaison linéaire des filtres des figures 1 et 4 selon un autre mode de réalisation de l'invention ;
- les figures 6a et 6b illustrent un dispositif numérique à retard factionnaire comprenant un filtre interpolateur selon un autre mode de réalisation de l'invention ;
- les figures 7a, 7b et 7c illustrent un équipement de réception radiofréquence multimode comprenant deux dispositifs de changement de rythme d'échantillonnage implémentant chacun le dispositif numérique de la figure 3a ;

- la figure 8 illustre un dispositif de pilotage, selon un mode de réalisation de l'invention, d'un dispositif numérique à retard factionnaire selon l'invention ;
- la figure 9 illustre un dispositif de pilotage, selon un autre mode de réalisation de l'invention, d'un dispositif numérique à retard factionnaire selon l'invention.

## 5 DESCRIPTION DETAILLEE DE L'INVENTION

Sur toutes les figures du présent document, les éléments et étapes identiques sont désignés par une même référence.

Le principe général de la technique décrite consiste à implémenter un dispositif numérique à retard factionnaire comprenant un filtre interpolateur numérique délivrant une série d'échantillons de sortie approximant un signal $x(t)$ à des instants d'échantillonnage de la forme $(n + d)T_s$ sur la base d'une série d'échantillons d'entrée du signal $x(t)$ pris à des instants d'échantillonnage de la forme $nT_s$, avec $n$ un entier, $T_s$ la période d'échantillonnage et $d$ un nombre réel représentatif du retard appliqué aux instants d'échantillonnage.

Plus particulièrement, le filtre interpolateur implémente une fonction de transfert dans le domaine transformé en Z, $H_c^d(Z^{-1})$, s'exprimant comme une combinaison linéaire entre :

- une première fonction de transfert $H_1^d(Z^{-1})$ représentant une interpolation polynomiale de type Lagrange des échantillons d'entrée implémentée selon une structure de Newton ; et

- une deuxième fonction de transfert $H_2^d(Z^{-1})$ représentant une autre interpolation polynomiale des échantillons d'entrée implémentée selon une autre structure comprenant au moins la structure de Newton en question.

Par la terminologie « implémenter une fonction de transfert selon une structure donnée », on entend dans la présente demande que l'implémentation matérielle du filtre en question correspond (en termes de fonctionnalités utilisées) aux expressions mathématiques explicitées dans la fonction de transfert considérée. Il y a ainsi une relation directe entre l'expression de la fonction de transfert considérée et l'implémentation matérielle correspondante.

Par ailleurs, la combinaison linéaire est fonction d'au moins un paramètre de combinaison c réel.

L'implémentation matérielle globale du dispositif numérique comprenant le filtre interpolateur tire ainsi parti de la synergie entre la structure de Newton implémentant la première fonction de transfert $H_1^d(Z^{-1})$ et la structure implémentant la deuxième fonction de transfert $H_2^d(Z^{-1})$.

Par ailleurs, la combinaison linéaire permet de paramétrer de manière simple la réponse globale du filtre interpolateur entre les réponses des deux interpolations polynomiales en question.

Dans un mode de réalisation, la deuxième fonction de transfert $H_2^d(Z^{-1})$ est exprimée au moins en partie sur une base de polynômes en $Z^{-1}$ correspondant à une implémentation de la première fonction de transfert $H_1^d(Z^{-1})$ selon la structure de Newton. Ceci afin de faciliter la réutilisation de la structure de Newton en question. Une telle base, dite base transformée dans la suite de la description, comprend des polynômes de la forme $(1 - Z^{-1})^k$, avec $k$ un entier, comme décrit ci-dessous.

Dans ce but, la méthode divulguée dans l'article précité de Lamb et al. est généralisée à une interpolation d'un ordre quelconque. Une telle méthode généralisée permet en effet de déterminer une expression de la deuxième fonction de transfert $H_2^d(Z^{-1})$ dans la base transformée à partir d'une expression de la même fonction de transfert, mais exprimée dans une base adaptée à une implémentation de type Farrow symétrisée.

Une telle méthode est ainsi d'intérêt dans la mesure où une structure de Farrow, même symétrisée, permet d'implémenter une interpolation polynômiale quelle que soit la nature des polynômes mis en jeu. Une expression de la fonction de transfert de tout type d'interpolation polynomiale peut ainsi être obtenue dans la base transformée grâce à une telle méthode.

Pour ce faire, une expression de la réponse impulsionnelle $h(t)$ d'un filtre implémentant l'interpolation polynomiale considérée doit tout d'abord être obtenue afin de déterminer la matrice de Farrow correspondante.

Plus particulièrement, une telle réponse impulsionnelle $h(t)$ s'exprime sous la forme d'une concaténation de N tronçons de polynômes $\beta_j(\mu) = \sum_{i=1}^{N} p_{i,j}\,\mu^{i-1}$, avec $\mu \in [-1/2; 1/2[$ et i et j deux entiers allant chacun de 1 à N, les

polynômes $\beta_j(\mu)$ étant translatés sur des segments temporels successifs de sorte que :

$$h(t) = \sum_{j=1}^{N} \beta_j \left( \frac{t}{T_s} - j + \frac{1}{2} \right) \quad \text{(Eq-1)}$$

Par ailleurs, selon la définition considérée dans la présente demande, la réponse impulsionnelle $h(t)$ est centrée sur l'axe temporel de manière à présenter une symétrie en $t/T_s = (N + 1)/2$. En d'autres termes, les N polynômes $\beta_j(\mu)$ vérifient $\beta_j(\mu) = +\beta_{N-j+1}(\mu)$ ou $\beta_j(\mu) = -\beta_{N-j+1}(\mu)$ suivant que la symétrie est paire ou impaire.

De la sorte, la matrice P constituée des éléments $p_{i,j}$ est une matrice de Farrow symétrisée telle qu'introduite dans l'article précité de Valimaki.

En se référant à l'article précité de Lamb et al., le changement de base depuis la base de Farrow vers la base transformée est obtenu par l'opération matricielle :

$$Q = \left( T_d^T \right)^{-1} P T_z^{-1} \quad \text{(Eq-2)}$$

avec :

- $T_d$ une matrice de N lignes et N colonnes transformant un vecteur $\vec{\mu}$ = [1, $\mu$, $\mu$2, ..., $\mu^{N-1}$] en un vecteur $\vec{d} = [1, d, d(d+1), ..., \prod_{i=0}^{N-2}(d+i)]$, avec d = $\mu$ - (N - 1)/2 ; et

- $T_z$ une matrice de N lignes et N colonnes transformant un vecteur $\vec{Z}$ = [1, $z^{-1}$, $z^{-2}$, ... , $z^{-(N-1)}$] en un vecteur $\overrightarrow{\nabla Z}$ = [1, (1 - $z^{-1}$), (1 - $z^{-1}$)², ... , (1 - $z^{-1}$)$^{N-1}$].

Plus particulièrement, la matrice $T_d$ s'exprime comme un produit de matrices $T_d$ = $T_d^2 T_d^1$, avec $T_d^1$ et $T_d^2$ deux matrices de N lignes et N colonnes. L'élément $T_d^1[i,j]$, d'indice de ligne i et d'indice de colonne j, de la matrice $T_d^1$ est égal à $\binom{i-1}{j-1}\left(-\frac{N-1}{2}\right)^{i-j}$, avec $\binom{i-1}{j-1}$ le coefficient binomial lu $j$ - 1 parmi $i$ - 1. De même, l'élément $T_d^2[i,j]$, d'indice de ligne i et d'indice de colonne j, de la matrice $Td$, est égal au nombre de Stirling de première espèce $S_{j-1}^{(i-1)}$.

Par ailleurs, l'élément $T_z[i,j]$, d'indice de ligne i et d'indice de colonne j, de la matrice $T_z$ est égal à $\binom{i-1}{j-1}(-1)^{j+1}$ avec $\binom{i-1}{j-1}$ le coefficient binomial lu $j$ - 1 parmi $i$ - 1.

Le changement de base en question permet ainsi d'obtenir la fonction de transfert $H^d(Z^{-1})$ du filtre implémentant l'interpolation polynômiale considérée dans la base transformée sous la forme :

$$H^d(Z^{-1}) = \sum_{n=1}^{N} q_{n,1}(1 - Z^{-1})^{n-1} + \sum_{n=1}^{N} \sum_{m=2}^{N} q_{n,m} \left[ (1 - Z^{-1})^{n-1} \prod_{i=0}^{m-2}(d+i) \right]$$

$$\text{(Eq-3)}$$

avec $q_{n,m}$ les éléments de la matrice Q de N lignes et N colonnes.

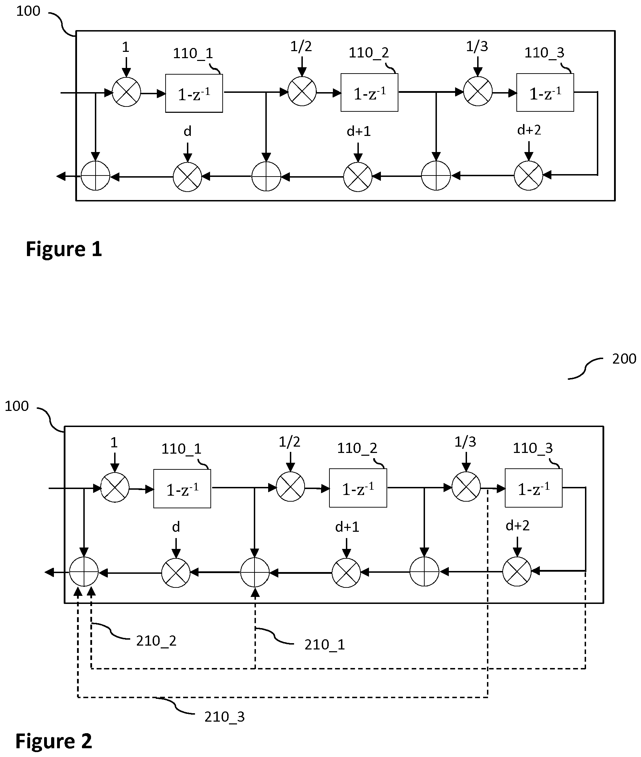

En particulier, la fonction de transfert $H^d(Z^{-1})$ d'un filtre interpolateur implémentant une interpolation de Lagrange exprimée dans la base transformée correspond à une implémentation selon une structure de Newton comme discuté dans l'article précité de Lamb et al., et comme illustré ci-dessous en relation avec la figure 1.

En effet, on décrit maintenant en relation avec la **figure 1** un filtre interpolateur connu implémentant une interpolation de Lagrange d'ordre trois implémentée selon une structure de Newton 100.

Afin d'obtenir une expression de la fonction de transfert $H_L^d(Z^{-1})$ du filtre interpolateur en question dans la base transformée, la méthode de changement de base décrite ci-dessus est par exemple appliquée.

Plus particulièrement, une expression de la réponse impulsionnelle $h(t)$ du filtre en question est tout d'abord obtenue afin de déterminer la matrice de Farrow symétrisée $P_L$ correspondante.

Pour ce faire, il est remarqué qu'une telle interpolation cherche à construire le polynôme $y(t)$ qui passe par les N échantillons $x[j]$, j de 1 à N, du signal d'entrée $x(t)$, de sorte que :

$$y(t) = \sum_{j=1}^{N} L_{(N-j+1)}\left(\frac{t}{T_s}\right) x[j]$$

avec $t/T_s \in [N/2 - 1; N/2[$.

Les polynômes de Lagrange sont connus et définis suivant :

$$L_j\left(\frac{t}{T_s}\right) = \prod_{\substack{k=0 \\ k \neq j-1}}^{N-1} \frac{\frac{t}{T_s} - k}{k - j + 1}$$

Afin d'obtenir une réponse impulsionnelle centrée sur l'axe du temps de manière à présenter une symétrie, ici paire, en $t/T_s = (N + 1)/2$, les polynômes $L_j\left(\frac{t}{T_s}\right)$ tels que définis ci-dessus sont translatés le long de l'axe temporel d'une valeur égale à $T_s(N - 1)/2$. De la sorte, les polynômes $\beta_j(\mu)$ requis pour définir la matrice $P_L$ sont obtenus selon :

$$\beta_j(\mu) = L_j\left(\mu + \frac{N-1}{2}\right) = \prod_{\substack{k=0 \\ k \neq j-1}}^{N-1} \frac{\mu + \frac{N-1}{2} + k}{k - j + 1}$$

avec $\mu \in [-1/2; 1/2[$.

De la sorte, pour N = 4, on obtient :

$$\beta_1(t) = \frac{1}{48}(8\mu^3 + 12\mu^2 - 2\mu - 3)$$
$$\beta_2(t) = \frac{1}{48}(-24\mu^3 - 12\mu^2 + 54\mu + 27)$$
$$\beta_3(t) = \frac{1}{48}(24\mu^3 - 12\mu^2 - 54\mu + 27)$$
$$\beta_4(t) = \frac{1}{48}(-8\mu^3 + 12\mu^2 + 2\mu - 3)$$

Ainsi, la matrice de Farrow symétrisée $P_L$ correspondant à l'interpolation de Lagrange d'ordre trois s'exprime selon nos définitions comme :

$$P_L = \frac{1}{48}\begin{pmatrix} -3 & 27 & 27 & -3 \\ -2 & 54 & -54 & 2 \\ 12 & -12 & -12 & 12 \\ 8 & -24 & 24 & -8 \end{pmatrix}$$

Il est noté que cette expression diffère de l'équation (3) de la publication précitée de Lamb et al. à cause d'un choix différent dans la définition du paramètre $\mu$ (choisi ici comme l'opposé de celui de la publication en question).

Par ailleurs, sur la base des expressions générales des éléments des matrices $T_d$ et $T_z$ données ci-dessus, les matrices $\left(T_d^T\right)^{-1}$ et $T_z^{-1}$ s'expriment dans le cas N = 4 comme :

$$\left(T_d^T\right)^{-1} = \begin{pmatrix} 1 & 3/2 & 9/4 & 27/8 \\ 0 & 1 & 2 & 13/4 \\ 0 & 0 & 1 & 3/2 \\ 0 & 0 & 0 & 1 \end{pmatrix} \quad \text{(Eq-4)}$$

et :

$$T_z^{-1} = \begin{pmatrix} 1 & 0 & 0 & 0 \\ 1 & -1 & 0 & 0 \\ 1 & -2 & 1 & 0 \\ 1 & -3 & 3 & -1 \end{pmatrix} \quad \text{(Eq-5)}$$

De la sorte, la matrice $Q_L$ obtenue par l'équation (Eq-2) s'exprime dans le cas présent comme :

$$Q_L = \begin{pmatrix} 1 & 0 & 0 & 0 \\ 0 & 1 & 0 & 0 \\ 0 & 0 & 1/2 & 0 \\ 0 & 0 & 0 & 1/6 \end{pmatrix}$$

Comme attendu, le changement de base effectué conduit à une expression de la matrice $Q_L$ diagonale. La fonction de transfert associée $H_L^d(Z^{-1})$ , obtenue à partir de la matrice $Q_L$ via l'équation (Eq-3), correspond alors à une implémentation sous la forme d'une structure 100 ne mettant en oeuvre que trois lignes à retard 110_1, 110_2, 110_3 de la forme $(1 - Z^{-1})^k$, avec $k$ un entier de 1 à 3.

La base transformée utilisée pour exprimer la fonction de transfert $H_L^d(Z^{-1})$ de l'interpolation de Lagrange conduit ainsi à une implémentation particulièrement efficace en termes calculatoires, connue sous le nom de structure de Newton 100.

On décrit maintenant, en relation avec la **figure 2** un filtre interpolateur connu implémentant une interpolation de type Spline d'ordre trois implémentée selon une structure quasi-Newton 200.

Plus particulièrement, une telle structure 200 correspond à une expression de la fonction de transfert $H_S^d(Z^{-1})$ du filtre interpolateur en question dans la base transformée.

À ce titre, la méthode de changement de base décrite ci-dessus est par exemple appliquée afin d'obtenir l'expression de la fonction de transfert en question.

Là encore, une expression de la réponse impulsionnelle $h(t)$ du filtre en question est tout d'abord obtenue afin de déterminer la matrice de Farrow symétrisée $P_S$ correspondante.

Pour ce faire, il est remarqué qu'une telle interpolation cherche à construire le polynôme $y(t)$ qui passe par les N échantillons $x[j]$, j de 1 à N, du signal d'entrée $x(t)$, de sorte que :

$$y(t) = \sum_{j=1}^{N} S_{(N-j+1)}\left(\frac{t}{T_s} + \frac{N}{2} - j + 1\right) x[j]$$

avec $t/T_s \in [N/2 - 1 ; N/2[$.

Les polynômes $S_{(j)}\left(\frac{t}{T_s}\right)$ de type Spline considérés ici sont déterminés par exemple via la méthode décrite dans l'article de Gradimir V. Milovanovié et Zlatko Udovicic, « *Calculation of coefficients of a cardinal B-spline,* » in Applied Mathematics Letters, Volume 23, Issue 11, 2010, Pages 1346-1350.

Plus particulièrement, le support temporel du polynôme $S_{(j)}\left(\frac{t}{T_s}\right)$ obtenu par cette méthode s'étend sur l'intervalle [j - 1; j[. De la sorte, les polynômes $\beta_j(\mu)$, avec $\mu \in$ [-1/2; 1/2[, définissant la réponse impulsionnelle cherchée via l'équation (Eq-1) sont obtenus via la translation temporelle :

$$\beta_j(\mu) = S_j\left(\mu + j - \frac{1}{2}\right)$$

Il en résulte dans l'exemple qui nous intéresse, i.e. pour N = 4, que :

$$\beta_1(t) = \frac{1}{48}(8\mu^3 + 12\mu^2 + 6\mu + 1)$$

$$\beta_2(t) = \frac{1}{48}(-24\mu^3 - 12\mu^2 + 30\mu + 23)$$

$$\beta_3(t) = \frac{1}{48}(24\mu^3 - 12\mu^2 - 30\mu + 23)$$

$$\beta_4(t) = \frac{1}{48}(-8\mu^3 + 12\mu^2 - 6\mu + 1)$$

Ainsi, la matrice de Farrow symétrisée $P_S$ correspondant à l'interpolation de type Spline d'ordre trois s'exprime selon nos définitions comme :

$$P_S = \frac{1}{48}\begin{pmatrix} 1 & 23 & 23 & 1 \\ 6 & 30 & -30 & -6 \\ 12 & -12 & -12 & 12 \\ 8 & -24 & 24 & -8 \end{pmatrix}$$

Il est noté là encore que cette expression diffère de l'équation (8) de la publication précitée de Lamb et al. à cause d'un choix différent dans la définition du paramètre $\mu$ (choisi ici comme l'opposé de celui de la publication en question).

Par ailleurs, sur la base des expressions des matrices $\left(T_d^T\right)^{-1}$ et $T_z^{-1}$ données respectivement par les équations (Eq-4) et (Eq-5), la matrice $Q_S$ obtenue par l'équation (Eq-2) s'exprime dans le cas présent comme :

$$Q_S = \begin{pmatrix} 1 & 0 & 1/6 & 1/6 \\ 0 & 1 & 0 & 1/6 \\ 0 & 0 & 1/2 & 0 \\ 0 & 0 & 0 & 1/6 \end{pmatrix}$$

On observe ainsi que :

-   la diagonale de la matrice $Q_S$ est identique à celle de la matrice $Q_L$ obtenue ci-dessus pour une interpolation de Lagrange d'ordre 3 ; et
-   seuls trois éléments extra diagonaux de la matrice $Q_S$ sont non nuls. En d'autres termes, la matrice $Q_S$ est creuse.

Ces deux caractéristiques de la matrice $Q_S$ se retrouvent au niveau de l'implémentation de la fonction de transfert associée, $H_S^d(Z^{-1})$ , lorsque cette implémentation est basée sur l'usage de lignes à retard de la forme (1 - $Z^{-1})^k$ correspondant à une expression de $H_S^d(Z^{-1})$ dans la base transformée $(H_S^d(Z^{-1})$ étant obtenue à partir de la matrice $Q_S$ via l'équation (Eq-3)).

Plus particulièrement, l'implémentation en question comprend :

- la structure de Newton 100, implémentant le filtre interpolateur de Lagrange décrit en relation avec la figure 1 ; et
- trois boucles de retour additionnelles 210_1, 210_2, 210_3 (flèches en pointillés sur la figure 2) entre une sortie d'une ligne à retard (de la forme $(1 - Z^{-1})^k$) de la structure de Newton 100 et la sortie de la structure de Newton 100. En pratique, de tels bouclages se font soit directement vers la sortie de la structure de Newton 100 (cas des boucles 210_2 et 210_3), soit indirectement, i.e. via d'autres éléments de la boucle de retour initiale de la structure de Newton 100 (cas de la boucle 210_1).

De par le faible nombre de boucles de retour additionnelles 210_1, 210_2, 210_3 (i.e. la matrice $Q_S$ est creuse), une telle implémentation correspond à une structure dite quasi-Newton 200.

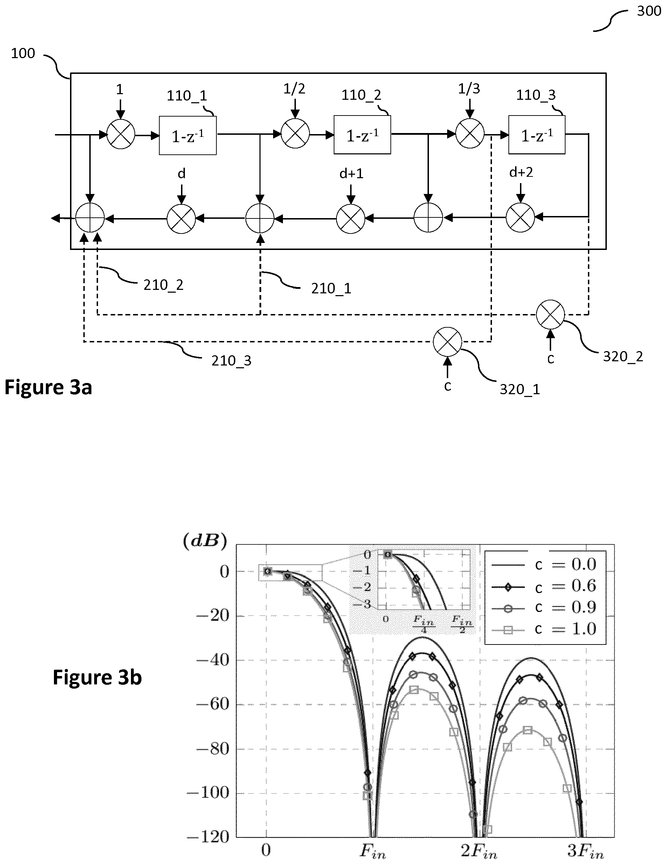

On décrit maintenant, en relation avec les **figures 3a et 3b** un dispositif numérique à retard factionnaire comprenant un filtre interpolateur résultant d'une combinaison linéaire des filtres des figures 1 et 2 selon un mode de réalisation de l'invention.

Plus particulièrement, le filtre interpolateur selon ce mode de réalisation implémente une interpolation polynomiale d'ordre 3 dont une fonction de transfert dans le domaine transformé en Z, $H_{LS}^d(Z^{-1})$, s'exprime comme une combinaison linéaire entre :

- la fonction de transfert $H_L^d(Z^{-1})$ représentant le filtre interpolateur de Lagrange de la figure 1 implémenté selon la structure de Newton 100 ; et

- la fonction de transfert $H_S^d(Z^{-1})$ représentant le filtre interpolateur de type Spline de la figure 2 implémenté selon la structure quasi-Newton 200.

Plus particulièrement, dans ce mode de réalisation, la fonction de transfert $H_{LS}^d(Z^{-1})$ s'exprime comme :

$$H_{LS}^d(Z^{-1}) = H_L^d(Z^{-1}) + c\left(H_S^d(Z^{-1}) - H_L^d(Z^{-1})\right)$$

Ainsi, la fonction de transfert $H_{LS}^d(Z^{-1})$ apparaît comme paramétrable en fonction du paramètre de combinaison $c$. Plus particulièrement, l'amplitude de la fonction de transfert $H_{LS}^d(Z^{-1})$ du filtre selon l'invention varie entre l'amplitude de la fonction de transfert $H_L^d(Z^{-1})$ de l'interpolation de Lagrange d'ordre trois pour $c = 0$ et celle de la fonction de transfert $H_S^d(Z^{-1})$ de l'interpolation de type Spline de même ordre pour $c = 1$ comme illustré sur la figure 3b. Par ailleurs, une valeur de $c$ supérieure à 1 peut également être utilisée.

De manière équivalente, il est obtenu par linéarité de l'équation (Eq-3) que la matrice $Q_{LS}$, représentant la fonction $H_{LS}^d(Z^{-1})$ dans la base transformée, s'exprime comme :

$$Q_{LS} = Q_L + c(Q_S - Q_L)$$

À partir des expressions des matrices $Q_L$ et $Q_S$ obtenues ci-dessus en relation respectivement avec les figures 1 et 2, la matrice $Q_{LS}$ s'exprime comme :

$$Q_{LS} = \begin{pmatrix} 1 & 0 & c/6 & c/6 \\ 0 & 1 & 0 & c/6 \\ 0 & 0 & 1/2 & 0 \\ 0 & 0 & 0 & 1/6 \end{pmatrix}$$

La structure 300 correspondante (figure 3a) est similaire à la structure quasi-Newton 200 de la figure 2. Seules les trois boucles de retour additionnelles 210_1, 210_2, 210_3 diffèrent en ce qu'elles sont pondérées par le paramètre de combinaison *c*. En pratique, une telle pondération est réalisée par exemple par un multiplieur 320_1, 320_2 sur les boucles de retour en question, un opérande des multiplieurs 320_1 et 320_2 étant proportionnel au paramètre de combinaison *c*.

Plus particulièrement, la structure 300 apparaît comme étant une structure de Newton modifiée qui implémente :

- la structure de Newton 100 lorsque le paramètre de combinaison *c* vaut 0 ; et
- la structure quasi-Newton 200 lorsque le paramètre de combinaison *c* vaut 1.

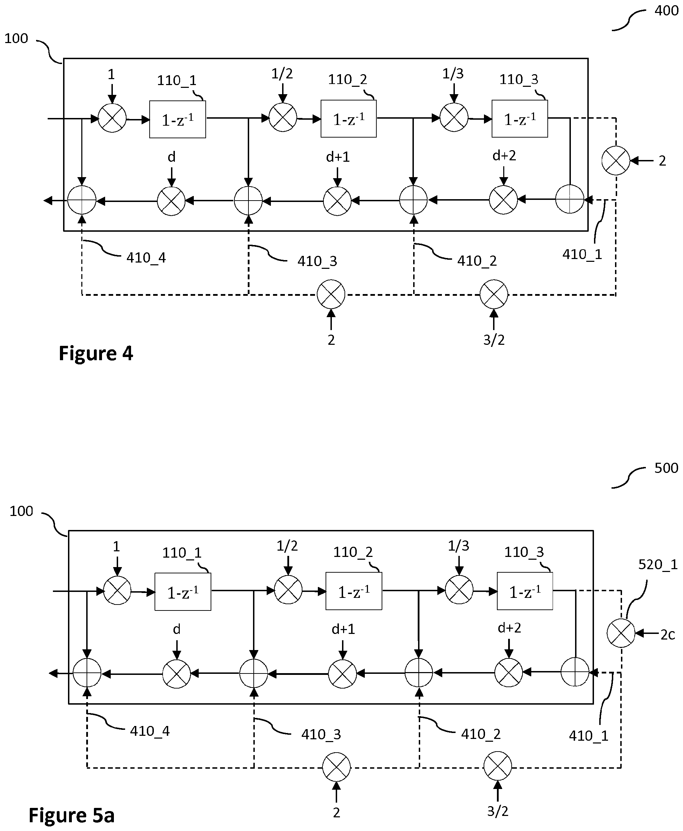

On décrit maintenant, en relation avec la **figure 4** un filtre interpolateur connu implémentant une interpolation d'Hermite d'ordre trois implémentée selon une structure quasi-Newton 400.

Plus particulièrement, une telle structure 400 correspond à une expression de la fonction de transfert $H_H^d(Z^{-1})$ du filtre interpolateur en question dans la base transformée.

À ce titre, la méthode de changement de base décrite ci-dessus est par exemple appliquée afin d'obtenir l'expression de la fonction de transfert en question.

Là encore, une expression de la réponse impulsionnelle *h(t)* du filtre en question est tout d'abord obtenue afin de déterminer la matrice de Farrow symétrisée $P_S$ correspondante. Cependant, dans le cas de l'interpolation d'Hermite, la dérivée des polynômes doit également être estimée aux points d'échantillonnage du signal en plus des polynômes eux-mêmes.

Plus particulièrement, une telle interpolation cherche à construire le polynôme *y(t)* qui passe par les $N_P$ échantillons *x[j]*, j de 1 à $N_P$, du signal d'entrée *x(t)*, tout en imposant l'égalité des dérivées de *y(t)* et du signal interpolé *x(t)* aux mêmes points d'échantillonnage *x[j]*. En d'autres termes, on obtient $N_H = N_P(p + 1)$ contraintes de la forme :

$$y^{(i)}(jT_s) = x^{(i)}[j]$$

avec $i \in \{0,1,2, ..., p\}, j \in \{1,2, ..., N_P\}$, et $.^{(i)}$ qui indique la dérivée d'ordre i.

Le polynôme *y(t)* s'exprime ainsi de manière générale comme :

$$y(t) = \sum_{i=1}^{N_H} a_i t^{i-1}$$

Les $N_H$ contraintes appliquées aux $N_H$ inconnues $a_i$ conduisent à un système linaire de $N_H$ équations dont la résolution permet d'exprimer les coefficients $a_i$ en fonction des valeurs des échantillons *x[j]*. À partir de l'expression en question des coefficients $a_i$, il apparaît que le polynôme *y(t)* peut se réécrire de manière générale sous la forme :

$$y(t) = \sum_{i=0}^{p} \sum_{j=1}^{N_P} \alpha_{i,j}(t) x^{(i)}[j]$$

Afin de décrire un filtre interpolateur d'ordre trois dont la fonction de transfert soient modélisable par des matrices $P_S$ et $Q_S$ qui soient carrées et de taille $4 \times 4$ (afin de pouvoir les combiner avec les matrices $P_L$ et $Q_L$ du filtre de la figure 1 pour d'obtenir le filtre selon l'invention décrit ci-dessous en relation avec la figure 5a), il est considéré le cas $N_p = 2$ et $p = 1$.

De la sorte, les valeurs suivantes des polynômes $a_{i,j}(t)$ sont obtenues :

$$\alpha_{0,1}(t) = 2t^3 - 3t^2 + 1$$

$$\alpha_{1,1}(t) = -2t^3 + 3t^2$$

$$\alpha_{0,2}(t) = t^3 - 2t^2 + t$$

$$\alpha_{1,2}(t) = t^3 - t^2$$

Par ailleurs, la méthode d'ordre 2 d'estimation des dérivées telle qu'utilisée par exemple dans l'article de Soontornwong, P., Chivapreecha, S. & Pradabpet, C. « A Cubic Hermite variable fractional delay filter Intelligent Signal Processing and Communications Systems » (ISPACS), 2011 International Symposium on, 2011, pp1-4, est mise en oeuvre pour estimer les dérivées $x^{(i)}$ [j] du signal $x(t)$ aux points d'échantillonnage $x[j]$. Ainsi, $\gamma = 2$ deux échantillons sont utilisés pour estimer la valeur d'une dérivée en un point donné.

De la sorte, les polynômes d'Hermite $H_j\left(\dfrac{t}{T_s}\right)$ sont finalement déterminés, de sorte que $y(t)$ s'exprime comme :

$$y(t) = \sum_{j=1}^{N} H_{(N-j+1)}\left(\frac{t}{T_s}\right)x[j]$$

avec $t/T_s \in [N_P/2 - 1; N_P/2[$, et $N = N_P + \gamma = 4$.

Les polynômes $\beta j(\mu)$, avec $\mu \in [-1/2; 1/2[$, définissant la réponse impulsionnelle cherchée via l'équation (Eq-1) sont ainsi obtenus via la translation temporelle :

$$\beta_j(\mu) = H_j\left(\mu + \frac{N_P - 1}{2}\right)$$

Il en résulte dans l'exemple qui nous intéresse, i.e. pour $N = N_P + \gamma = 4$, que :

$$\beta_1(t) = \frac{1}{48}(8\mu^3 + 4\mu^2 - 2\mu - 1)$$
$$\beta_2(t) = \frac{1}{48}(-24\mu^3 - 4\mu^2 + 22\mu + 9)$$
$$\beta_3(t) = \frac{1}{48}(24\mu^3 - 4\mu^2 - 22\mu + 9)$$
$$\beta_4(t) = \frac{1}{48}(-8\mu^3 + 4\mu^2 + 2\mu - 1)$$

Ainsi, la matrice de Farrow symétrisée $P_H$ correspondant à l'interpolation d'Hermite d'ordre trois considérée s'exprime selon nos définitions comme :

$$P_H = \frac{1}{16}\begin{pmatrix} -1 & 9 & 9 & -1 \\ -2 & 22 & -22 & 2 \\ 4 & -4 & -4 & 4 \\ 8 & -24 & 24 & -8 \end{pmatrix}$$

Par ailleurs, sur la base des expressions des matrices $\left(T_d^T\right)^{-1}$ et $T_z^{-1}$ données respectivement par les équations (Eq-4) et (Eq-5), la matrice $Q_H$ obtenue par l'équation (Eq-2) s'exprime dans le cas présent comme :

$$Q_H = \begin{pmatrix} 1 & 0 & 0 & 1 \\ 0 & 1 & 0 & 1 \\ 0 & 0 & 1/2 & 1/2 \\ 0 & 0 & 0 & 1/6 + 1/3 \end{pmatrix}$$

On observe ainsi que :

- la diagonale de la matrice $Q_H$ s'exprime comme celle de la matrice $Q_L$ (obtenue ci-dessus pour une interpolation de Lagrange d'ordre 3) à laquelle le terme 1/3 est ajouté à la dernière valeur de la diagonale ; et
- seuls trois éléments extra diagonaux de la matrice $Q_H$ sont non nuls. En d'autres termes, la matrice $Q_H$ est également creuse, tout comme la matrice $Q_S$ obtenue ci-dessus en relation avec la figure 2.

Ces deux caractéristiques de la matrice $Q_H$ se retrouvent au niveau de l'implémentation de la fonction de transfert associée, $H_H^d(Z^{-1})$, lorsque cette implémentation est basée sur l'usage de lignes à retard de la forme (1 - $Z^{-1})^k$, correspondant à une expression de $H_H^d(Z^{-1})$ dans la base transformée ($H_H^d(Z^{-1})$ étant obtenue à partir de la matrice $Q_H$ via l'équation (Eq-3)).

Plus particulièrement, l'implémentation en question comprend :

- la structure de Newton 100, implémentant le filtre interpolateur de Lagrange décrit en relation avec la figure 1 ; et
- quatre boucles de retour additionnelles 410_1 à 410_4 (flèches en pointillés sur la figure 4) entre une sortie d'une ligne à retard (de la forme (1 - $Z^{-1})^k$) de la structure de Newton 100 et la sortie de la structure de Newton 100. Là encore, de tels bouclages se font soit directement vers la sortie de la structure de Newton 100 (cas de la boucle 410_4), soit indirectement, i.e. via d'autres éléments de la boucle de retour initiale de la structure de Newton 100 (cas des boucles 410_1, 410_2 et 410_3).

De par le faible nombre de boucles de retour additionnelles 410_1, 410_2, 410_3 (i.e. la matrice $Q_H$ est creuse et ne comprend que trois éléments extra diagonaux, comme la matrice $Q_S$ discutée ci-dessus en relation avec la figure 2), une telle implémentation correspond également à une structure dite quasi-Newton 400.

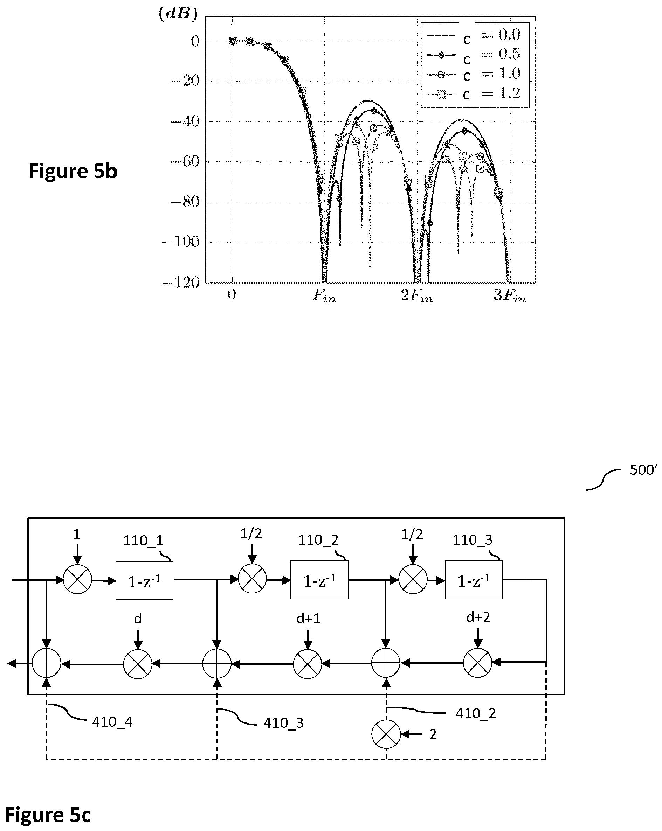

On décrit maintenant, en relation avec les **figures 5a et 5b** un dispositif numérique à retard factionnaire comprenant un filtre interpolateur résultant d'une combinaison linéaire des filtres des figures 1 et 4 selon un mode de réalisation de l'invention.

Plus particulièrement, le filtre interpolateur selon ce mode de réalisation implémente une interpolation polynomiale d'ordre 3 dont une fonction de transfert dans le domaine transformé en Z, $H_{LH}^d(Z^{-1})$, s'exprime comme une combinaison linéaire entre :

- la fonction de transfert $H_L^d(Z^{-1})$ représentant le filtre interpolateur de Lagrange de la figure 1 implémenté selon la structure de Newton 100 ; et
- la fonction de transfert $H_H^d(Z^{-1})$ représentant le filtre interpolateur de type Hermite de la figure 4 implémenté selon la structure quasi-Newton 400.

Plus particulièrement, dans ce mode de réalisation, la fonction de transfert $H_{LH}^d(Z^{-1})$ s'exprime comme :

$$H_{LH}^d(Z^{-1}) = H_L^d(Z^{-1}) + c\left(H_H^d(Z^{-1}) - H_L^d(Z^{-1})\right)$$

Ainsi, la fonction de transfert $H_{LH}^d(Z^{-1})$ apparaît comme paramétrable en fonction du paramètre de combinaison c. Plus particulièrement, l'amplitude de la fonction de transfert $H_{LH}^d(Z^{-1})$ du filtre selon l'invention varie entre l'amplitude de la fonction de transfert $H_L^d(Z^{-1})$ de l'interpolation de Lagrange d'ordre trois pour $c = 0$ et celle de la fonction de transfert $H_H^d(Z^{-1})$ de l'interpolation d'Hermite de même ordre pour $c = 1$ comme illustré sur la figure 5b. Par ailleurs, un paramètre de combinaison $c$ de valeur supérieure à 1 est également utilisable (ici $c = 1,2$ est également représenté).

De manière équivalente, il est obtenu par linéarité de l'équation (Eq-3) que la matrice $Q_{LH}$, représentant la fonction $H_{LH}^d(Z^{-1})$ dans la base transformée, s'exprime comme :

$$Q_{LH} = Q_L + c(Q_H - Q_L)$$

À partir des expressions des matrices $Q_L$ et $Q_H$ obtenues ci-dessus en relation respectivement avec les figures 1 et 4, la matrice $Q_{LH}$ s'exprime comme :

$$Q_{LH} = \begin{pmatrix} 1 & 0 & 0 & c \\ 0 & 1 & 0 & c \\ 0 & 0 & 1/2 & c/2 \\ 0 & 0 & 0 & 1/6 + c/3 \end{pmatrix}$$

La structure 500 correspondante (figure 5a) est similaire à la structure quasi-Newton 400 de la figure 4. Seules les boucles de retour additionnelles 410_1 à 410_4 diffèrent en ce qu'elles sont pondérées par le paramètre de combinaison $c$. En pratique, une telle pondération est réalisée par exemple via un multiplieur 520_1, ici sur la boucle de retour 410_1 qui se trouve être un tronçon commun aux différentes boucles de retour 410_1 à 410_4. Par ailleurs, un opérande du multiplieur 520_1 est proportionnel au paramètre de combinaison $c$.

Plus particulièrement, la structure 500 apparaît comme étant une structure de Newton modifiée qui implémente :

- la structure de Newton 100 lorsque le paramètre de combinaison $c$ vaut 0 ; et
- la structure quasi-Newton 400 lorsque le paramètre de combinaison $c$ vaut 1.

On décrit maintenant, en relation avec la **figure 5c** un dispositif numérique à retard fractionnaire comprenant un filtre interpolateur résultant d'une combinaison linéaire des filtres des figures 1 et 4 selon un autre mode de réalisation de l'invention.

Plus particulièrement, le filtre interpolateur selon ce mode de réalisation implémente une interpolation polynomiale d'ordre 3 dont une fonction de transfert $H_{LH,1/4}^{d}(Z^{-1})$ dans le domaine transformé en Z correspond à la fonction de transfert $H_{LH}^{d}(Z^{-1})$ du filtre de la figure 5a lorsque le paramètre de combinaison c est fixé à la valeur 1/4.

À partir de la fonction de transfert $H_{LH}^{d}(Z^{-1})$ obtenue ci-dessus en relation avec la figure 5a, la fonction de transfert $H_{LH,1/4}^{d}(Z^{-1})$ s'exprime ainsi comme :

$$H_{LH,1/4}^{d}(Z^{-1}) = H_{LH}^{d}(Z^{-1})\big|_{c=1/4} = H_L^{d}(Z^{-1}) + \frac{1}{4}\left(H_H^{d}(Z^{-1}) - H_L^{d}(Z^{-1})\right)$$

De manière équivalente, la matrice $Q_{LH,1/4}$, représentant la fonction $H_{LH,1/4}^{d}(Z^{-1})$ dans la base transformée, s'exprime comme :

$$Q_{LH,1/4} = Q_{LH}\big|_{c=1/4} = Q_L + \frac{1}{4}(Q_H - Q_L)$$

ou, à partir de l'expression de la matrice $Q_{LH}$ obtenue ci-dessus en relation avec la figure 5a :

$$Q_{LH,1/4} = \begin{pmatrix} 1 & 0 & 0 & 1/4 \\ 0 & 1 & 0 & 1/4 \\ 0 & 0 & 1/2 & 1/8 \\ 0 & 0 & 0 & 1/4 \end{pmatrix}$$

Il apparaît ainsi que la structure 500' correspondante n'est pas qu'une simple recopie de la structure 500 du filtre de la figure 5a dans le cas particulier où $c = 1/4$. En effet, la structure des termes de la matrices $Q_{LH}$ permet des simplifications arithmétiques lorsque le paramètre $c$ prend une valeur numérique fixe particulière. L'implémentation correspondante bénéficie alors des simplifications en question. Dans le cas présent où $c = 1/4$, la structure 500' correspondant à la matrice $Q_{LH,1/4}$ telle que définie ci-dessus implémente une structure de Newton modifiée ne comprenant qu'une partie de la structure de Newton 100. En particulier certains opérandes sont différents de ceux de la structure de Newton 100. Suivant les valeurs considérées du paramètre de combinaison $c$, l'implémentation d'un filtre interpolateur selon l'invention est ainsi particulièrement efficace lorsque le paramètre en question $c$ est fixe.

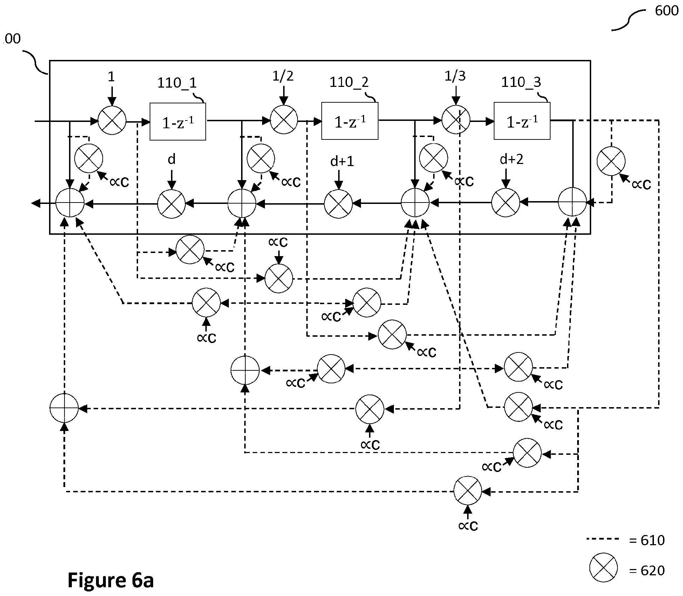

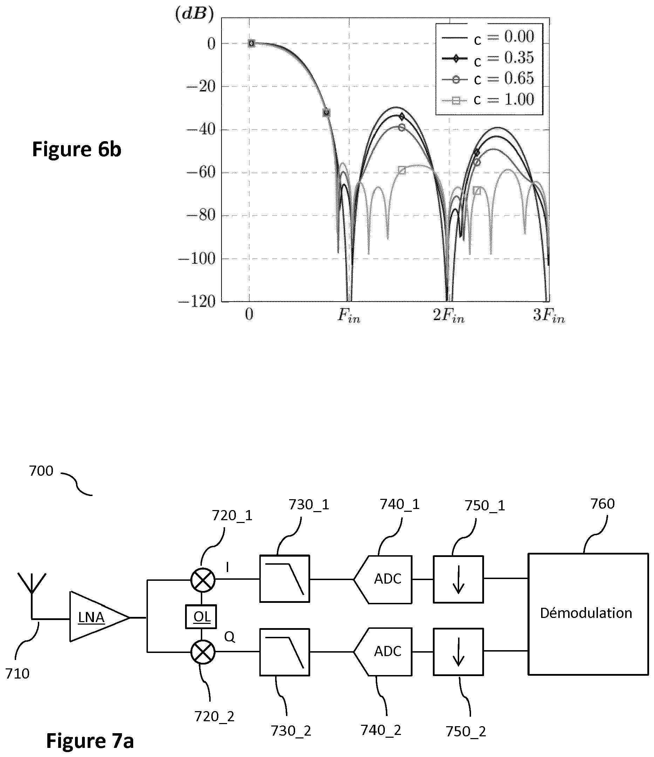

On décrit maintenant, en relation avec les **figures 6a et 6b** un dispositif numérique à retard fractionnaire comprenant un filtre interpolateur selon un autre mode de réalisation de l'invention.

Plus particulièrement, le filtre interpolateur selon ce mode de réalisation implémente une interpolation polynomiale d'ordre 3 dont une fonction de transfert dans le domaine transformé en Z, $H_{LP}^d(Z^{-1})$, s'exprime comme une combinaison linéaire entre :

- la fonction de transfert $H_L^d(Z^{-1})$ représentant le filtre interpolateur de Lagrange de la figure 1 implémenté selon la structure de Newton 100 ; et

- une fonction de transfert $H_P^d(Z^{-1})$ représentant un filtre implémentant une interpolation polynômiale personnalisée.

Par exemple, la fonction de transfert $H_P^d(Z^{-1})$ est générée via la méthode de synthèse de filtre décrite dans la thèse de Hunter, M. T. « Design of Polynomial-based Filters for Continuously Variable Sample Rate Conversion with Applications in Synthetic Instrumentation and Software Defined Radio, » University of Central Florida Orlando, Florida, 2008 de manière à vérifier les contraintes suivantes :

- une réponse impulsionnelle composée de quatre fonctions polynômiales ;
- une bande passante s'étendant sur la bande $[0; 0.2F_s]$, avec $F_s = 1/T_s$ la fréquence d'échantillonnage du signal d'entrée à interpoler ;
- une bande d'atténuation pour les fréquences supérieures à $F_s$.

Par ailleurs, les paramètres $W_{pass}$ et $W_{stop}$ de la méthode de synthèse précitée sont fixés à 25 de manière à donner la même importance à l'optimisation de la fonction de transfert du filtre en question dans sa bande passante et hors de sa bande passante. Ceci permet d'obtenir à la fois une bonne platitude dans la bande passante et une bonne atténuation des lobes secondaires. Comme illustré sur la figure 6b, la fonction de transfert obtenue présente un niveau de lobes secondaires qui est inférieur au lobe principal de 60d B.

Sur la base de ces contraintes, la méthode de synthèse fournit directement une expression pour la matrice de Farrow symétrisée $P_P$ correspondante :

$$P_P = \begin{pmatrix} 0.5127049464 & -1.2328513307 & 1.2328513307 & -0.5127049464 \\ 0.2728275037 & -0.2791909529 & -0.2791909529 & 0.2728275037 \\ -0.0548684879 & 1.1598793883 & -1.1598793883 & 0.0548684879 \\ -0.0405493896 & 0.5649430472 & 0.5649430472 & -0.0405493896 \end{pmatrix}$$

Par ailleurs, sur la base des expressions des matrices $\left(T_d^T\right)^{-1}$ et $T_z^{-1}$ données respectivement par les équations (Eq-4) et (Eq-5), la matrice $Q_P$ obtenue par l'équation (Eq-2) s'exprime dans le cas présent comme :

$$Q_P = \begin{pmatrix} 1.0201517939 & 0.9929475376 & -0.8664743440 & 1.0747639686 \\ -0.0254537968 & 2.0255610229 & -0.9087972112 & 1.0657675806 \\ -0.0127268984 & 0.4769856106 & 0.0813962953 & 0.4962299160 \\ 0.0000000000 & 0.3052635087 & -0.3052635087 & 0.5127049465 \end{pmatrix}$$

Dans ce mode de réalisation la fonction de transfert $H_{LP}^d(Z^{-1})$ s'exprime comme :

$$H_{LP}^d(Z^{-1}) = H_L^d(Z^{-1}) + c\left(H_P^d(Z^{-1}) - H_L^d(Z^{-1})\right)$$

Ainsi, l'amplitude de la fonction de transfert $H_{LP}^d(Z^{-1})$ du filtre selon l'invention varie entre l'amplitude de la fonction de transfert $H_L^d(Z^{-1})$ de l'interpolation de Lagrange d'ordre trois pour $c = 0$ et celle de la fonction de transfert $H_P^d(Z^{-1})$ de l'interpolation personnalisée de même ordre pour $c = 1$ comme illustré sur la figure 6b. Par ailleurs, une valeur de $c$ supérieure à 1 peut également être utilisée.

De manière équivalente, il est obtenu par linéarité de l'équation (Eq-3) que la matrice $Q_{LP}$, représentant la fonction $H_{LP}^d(Z^{-1})$ dans la base transformée, s'exprime comme :

$$Q_{LP} = Q_L + c(Q_P - Q_L)$$

À partir de l'expression de la matrice $Q_L$ obtenue ci-dessus en relation avec la figure 1, la matrice $Q_{LP}$ s'exprime comme :

$$Q_{LP} = \begin{pmatrix} 1 + c \times dq_{11} & c \times q_{12} & c \times q_{21} & c \times q_{14} \\ c \times q_{21} & 1 + c \times dq_{22} & c \times q_{21} & c \times q_{24} \\ c \times q_{31} & c \times q_{32} & 1/2 + c \times dq_{33} & c \times q_{34} \\ 0 & c \times q_{42} & c \times q_{43} & 1/6 + c \times dq_{44} \end{pmatrix}$$

avec $q_{i,j}$ les éléments de la matrice $Q_P$.

Plus particulièrement, la structure 600 correspondante (figure 6a) comprend ainsi :

- la structure de Newton 100, implémentant le filtre interpolateur de Lagrange décrit en relation avec la figure 1 ; et
- quinze boucles de retour additionnelles (flèches en pointillés sur la figure 6a référencées de manière générale 610 pour plus de clarté) entre une sortie d'une ligne à retard (de la forme $(1 - Z^{-1})^k$) de la structure de Newton 100 et la sortie de la structure de Newton 100. En pratique, de tels bouclages se font soit directement vers la sortie de la structure de Newton 100, soit indirectement, i.e. via d'autres éléments de la boucle de retour initiale de la structure de Newton 100.

Plus particulièrement, les quinze boucles de retour additionnelles 610 correspondent aux quinze éléments de la matrice $Q_{LP}$ qui sont pondérés par le paramètre de combinaison $c$. En pratique, une telle pondération est réalisée par des multiplieurs (également en pointillés sur la figure 6a et référencés de manière générale 620 pour plus de clarté) sur les boucles de retour 610 correspondantes. Par ailleurs, un opérande des multiplieurs 620 est proportionnel au paramètre de combinaison c.

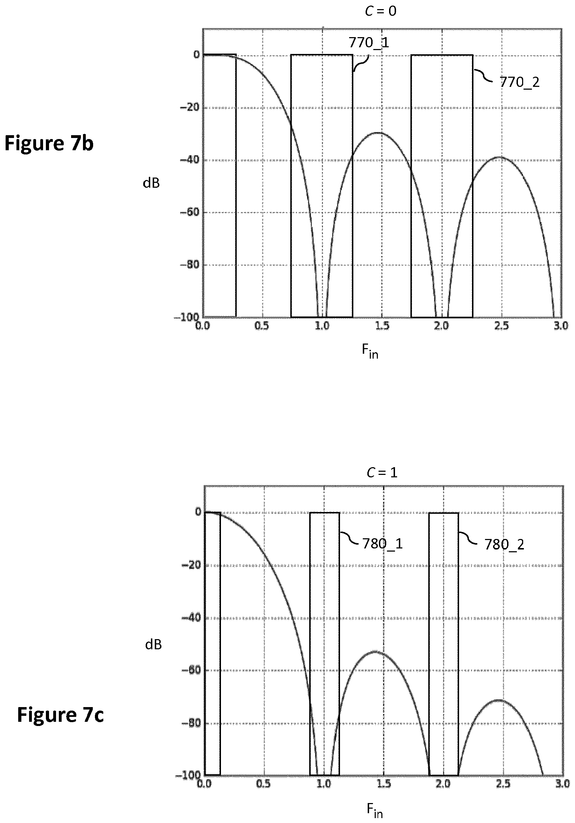

On décrit maintenant, en relation avec les **figures 7a, 7b et 7c** un équipement de réception 700 radiofréquence multimode comprenant deux dispositifs 730_1, 730_2 de changement de rythme d'échantillonnage implémentant chacun le dispositif numérique à retard fractionnaire de la figure 3a.

Plus particulièrement, l'équipement de réception 700 comprend une antenne 710 délivrant le signal radiofréquence à un amplificateur faible bruit LNA. L'amplificateur faible bruit LNA délivre le signal radiofréquence amplifié à deux mélangeurs 720_1, 720_2 séquencés par deux signaux en quadrature délivrés par un oscillateur local OL. Les deux signaux I et Q ainsi obtenus en bande de base sont filtrés par des filtres analogiques 730_1, 730_2 avant d'être échantillonnés à une fréquence d'échantillonnage $F_{in}$ par deux convertisseurs analogique numérique 740_1, 740_2.

Les signaux I et Q échantillonnés à la fréquence d'échantillonnage $F_{in}$ sont alors traités respectivement par deux dispositifs 750_1, 750_2 de changement de rythme d'échantillonnage implémentant chacun le filtre interpolateur de la figure 3a afin de délivrer des signaux I et Q échantillonnés à la fréquence d'échantillonnage $F_{out}$ plus adaptée à la démodulation par le bloc 760.

Par ailleurs, l'équipement de réception 700 est configuré pour fonctionner selon deux modes de réception. Dans un premier mode, l'équipement de réception 700 reçoit par exemple un signal du type LoRa® présentant une bande passante de 125kHz. Dans un deuxième mode, l'équipement de réception 700 reçoit par exemple un signal du type SigFox® présentant une bande passante de 100Hz.

Pour ce faire, les dispositifs 750_1, 750_2 implémentent chacun le filtre de la figure 3a dont la fonction de transfert $H_{LS}^d(Z^{-1})$ est paramétrable entre la fonction de transfert $H_L^d(Z^{-1})$ de l'interpolation de Lagrange d'ordre trois et celle de la fonction de transfert $H_S^d(Z^{-1})$ de l'interpolation de type Spline de même ordre en fonction du paramètre de combinaison $c$.

Lorsque $c = 0$, la fonction de transfert du type Lagrange est adaptée à l'atténuation des première 770_1 et deuxième 770_2 répliques du signal LoRa® échantillonné à la fréquence $F_{in}$ tout en préservant le signal utile centré sur la fréquence nulle (figure 7b).

Réciproquement, lorsque $c = 1$, la fonction de transfert du type Spline est mieux adaptée à l'atténuation des première 780_1 et deuxième 780_2 répliques du signal SigFox® échantillonné à la fréquence $F_{in}$ tout en préservant le signal utile centré sur la fréquence nulle (figure 7c). En effet, le signal SigFox® étant à bande plus étroite que la signal LoRa®, un filtrage plus agressif des répliques peut être envisagé tout en préservant le signal utile dans la bande passante du filtre.

De la sorte, la fonction de filtrage anti-repliement des dispositifs 730_1, 730_2 est obtenue de manière simple et paramétrable afin d'adresser les deux standards.

Par ailleurs, le retard $d$ est ici variable et reprogrammable à la volée entre deux échantillons du signal d'entrée afin de permettre également le changement de la fréquence d'échantillonnage de $F_{in}$ vers $F_{out}$.

De même, le paramètre $c$ prend ici les valeurs 0 ou 1. De la sorte, la fonction de transfert $H_{LS}^d(Z^{-1})$ est commutée entre la fonction de transfert $H_L^d(Z^{-1})$ et la fonction de transfert $H_S^d(Z^{-1})$ selon le mode de réception considéré.

Dans d'autres modes de réalisation adressant d'autres applications, le paramètre $d$ est statique et seul un retard sur l'instant d'échantillonnage est obtenu. Dans ce cas $F_{out} = F_{in}$.

Dans encore d'autres modes de réalisation, la paramètre $c$ est rendu variable et reprogrammable à la volée sur une plage de valeurs afin de permettre une variation continue de l'amplitude de la fonction de transfert du filtre selon l'invention entre l'amplitude de la première fonction de transfert $H_1^d(Z^{-1})$ et l'amplitude de la deuxième fonction de transfert $H_2^d(Z^{-1})$.

Dans encore d'autres modes de réalisation, la paramètre c est statique et prend une valeur prédéterminée de sorte que l'amplitude de la fonction de transfert du filtre selon l'invention résulte de la combinaison linéaire souhaitée entre l'amplitude de la première fonction de transfert $H_1^d(Z^{-1})$ et l'amplitude de la deuxième fonction de transfert

$$H_2^d(Z^{-1}).$$

Les différentes structures précitées 100, 200, 300, 400, 500, 600 de dispositifs numériques de filtrage selon l'invention peuvent être implémentées indifféremment sur une machine de calcul reprogrammable (un ordinateur PC, un processeur DSP ou un microcontrôleur) exécutant un programme comprenant une séquence d'instructions, ou sur une machine de calcul dédiée (par exemple un ensemble de portes logiques comme un FPGA ou un ASIC, ou tout autre module matériel) afin de mettre en oeuvre l'interpolation numérique selon l'invention.

Dans le cas où les structures de filtrage précitées sont réalisées avec une machine de calcul reprogrammable, le programme correspondant (c'est-à-dire la séquence d'instructions) pourra être stocké dans un médium de stockage amovible (tel que par exemple une disquette, un CD-ROM ou un DVD-ROM) ou non (une mémoire, volatile ou non), ce médium de stockage étant lisible partiellement ou totalement par un ordinateur ou un processeur. A l'initialisation, les instructions de code du programme d'ordinateur sont par exemple chargées dans une mémoire vive avant d'être exécutées par un processeur de l'unité de traitement.

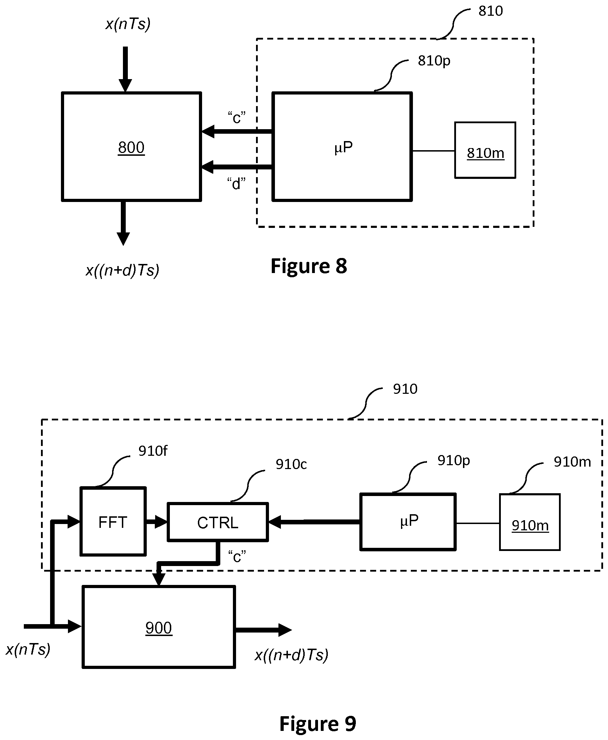

On décrit maintenant, en relation avec la **figure 8** un dispositif de pilotage 810 d'un dispositif numérique à retard fractionnaire 800 selon l'invention.

Par exemple, le dispositif numérique 800 est l'un des dispositifs numériques des figures 3a, 5b ou 6a.

Selon le mode de réalisation représenté sur la figure 8, un microcontrôleur 810p programme de manière statique le dispositif numérique 800, i.e. préalablement au traitement des échantillons $x(nT_s)$ du signal d'entrée $x(t)$ par le dispositif numérique 800. Ainsi, le dispositif numérique 800 délivre les échantillons de sortie approximant le signal d'entrée aux instants d'échantillonnage de la forme $(n + d)T_s$ après traitement via la mise en oeuvre des paramètres suivants préalablement reçus du microcontrôleur 810p :

-   le paramètre de combinaison $c$ ; et

- le nombre réel *d* définissant les instants fractionnaires d'échantillonnage.

Le **Tableau 1** ci-dessous donne des exemples de valeurs du paramètre *c* pour certains signaux du type LoRa® ou Sigfox®.

Tableau 1- Exemples de valeurs du paramètre *c* à appliquer au dispositif numérique de la figure 3a afin de traiter un signal LoRa® ou Sigfox®.

| Standard | Valeur du paramètre *c* |
|---|---|
| LoRa® 250kHz | 0.00 |
| LoRa® 125kHz | 0.25 |
| Sigfox® 100kHz | 1.00 |

Selon le mode de réalisation représenté sur la figure 8, de telles valeurs du paramètre c sont stockées dans une mémoire 810m du dispositif de pilotage 810 afin que le microcontrôleur 810p transmette la valeur adéquate au dispositif numérique 800 avant réception du signal LoRa® ou Sigfox® correspondant. Plus particulièrement, les valeurs du paramètre c données dans le Tableau 1 s'appliquent lorsque le dispositif numérique 800 correspond au dispositif numérique de la figure 3a.

On décrit maintenant, en relation avec la **figure 9** un autre dispositif de pilotage 910 d'un dispositif numérique à retard factionnaire 900 selon l'invention.

Par exemple, le dispositif numérique 900 est l'un des dispositifs numériques des figures 3a, 5b ou 6a.

Selon le mode de réalisation représenté sur la figure 9, le dispositif de pilotage 910 pilote de manière dynamique le dispositif numérique 900, i.e. à la volée pendant le traitement des échantillons $x(nT_s)$ du signal d'entrée $x(t)$ par le dispositif numérique 900. Ainsi, le dispositif numérique 900 délivre les échantillons de sortie approximant le signal d'entrée aux instants d'échantillonnage de la forme $(n + d)T_s$ après traitement via la mise en oeuvre du paramètre c reçu dynamiquement du contrôleur 910c.

Plus particulièrement, le contrôleur 910c détermine le paramètre c adapté au signal traité en se basant sur tout ou partie des informations suivantes :

- les caractéristiques du spectre (bande de signal utile, l'existence de signaux bloqueurs, etc.) du signal d'entrée $x(t)$. Le spectre en question est par exemple délivré par le bloc d'analyse spectrale 910f (implémentant par exemple une transformée de Fourier discrète des échantillons $x(nT_s)$ du signal d'entrée) ;
- le nombre réel d définissant les instants fractionnaires d'échantillonnage ; et
- la configuration d'autres modules de traitement du signal disposés soit en amont soit en aval du dispositif numérique 900. Par exemple un module de filtrage (e.g. un filtre FIR) placé en amont du dispositif numérique 900 peut permettre d'implémenter une pré-distorsion du signal devant être traité par le dispositif numérique 900. De la sorte, il est possible d'envisager un filtrage plus agressif au niveau du dispositif numérique 900. En effet, un tel filtrage plus agressif se fait au détriment d'une réduction de la largeur de la bande-passante du filtre compris dans le dispositif numérique 900. Cependant, la pré-distorsion précitée permet dans ce cas de compenser la tout ou partie de la distorsion liée à la réduction de la largeur de bande-passant en question. Par exemple, lorsque le dispositif numérique 900 correspond au dispositif numérique de la figure 3a, une telle pré-distorsion permet par exemple d'augmenter la valeur du paramètre c de combinaison linéaire de sorte à obtenir un filtrage hors bande plus agressif (i.e. qui s'approche plus d'un filtrage de type Spline que d'un filtrage de type Lagrange) et ainsi améliorer la réjection des lobes secondaire tout en préservant la qualité du signal utile grâce au module de pré-distorsion amont. Alternativement, si dans un mode de réception particulier (e.g. pendant la réception d'un signal selon un autre standard), le module amont de pré-distorsion ne peut plus être utilisé pour une raison donnée, le paramètre c est à nouveau ajusté par le dispositif de pilotage 910 afin de tenir compte de l'absence de pré-distorsion sur le signal devant être traité par le dispositif numérique 900. De même, le dispositif de pilotage 910 peut prendre en compte la présence éventuelle d'un autre module (e.g. un filtre FIR) placé en aval du dispositif numérique 900 afin de déterminer le paramètre *c*.

Par ailleurs, dans le mode de réalisation illustré sur la figure 9 le contrôleur 910c est lui-même contrôlé par un microcontrôleur 910p sur la base de paramètres et/ou d'instructions de code stocké(e)s dans une mémoire 910m.

**EP 3 729 299 B1**

**Revendications**

1. Dispositif de filtrage interpolateur numérique à retard fractionnaire d'un signal $x(t)$ délivrant une série d'échantillons de sortie approximant un signal $x(t)$ à des instants d'échantillonnage de la forme $(n + d)T_s$ sur la base d'une série d'échantillons d'entrée dudit signal $x(t)$ pris à des instants d'échantillonnage de la forme $nT_s$, avec $n$ un entier, $T_s$ une période d'échantillonnage et $d$ un nombre réel définissant les instants fractionnaires d'échantillonnage, ledit dispositif comprend :

   - une structure de Newton implémentant une première fonction de transfert $H_1^d(Z^{-1})$ représentant une interpolation polynomiale de type Lagrange desdits échantillons d'entrée implémentée selon une structure de Newton (100) ; et
   - une autre structure de Newton comprenant au moins ladite structure de Newton et implémentant une deuxième fonction de transfert $H_2^d(Z^{-1})$ représentant une autre interpolation polynomiale desdits échantillons d'entrée; **caractérisé en ce que** ledit dispositif comprend en outre une fonction de transfert dudit filtre dans le domaine transformé en Z, $H_c^d(Z^{-1})$ s'exprimant comme une combinaison linéaire entre la première fonction de transfert et la deuxième fonction de transfert et étant fonction d'au moins un paramètre de combinaison $c$ réel.

2. Dispositif selon la revendication 1 dans lequel ladite combinaison linéaire desdites première $H_1^d(Z^{-1})$ et deuxième $H_2^d(Z^{-1})$ fonctions de transfert s'exprime comme :

$$H_c^d(Z^{-1}) = H_1^d(Z^{-1}) + c\left(H_2^d(Z^{-1}) - H_1^d(Z^{-1})\right)$$

3. Dispositif selon la revendication 1 ou 2 dans lequel ladite autre structure est une structure quasi-Newton (200, 400).

4. Dispositif selon la revendication 3 dans lequel ladite autre interpolation polynomiale desdits échantillons d'entrée appartient au groupe comprenant :

   - une interpolation polynomiale de type Spline desdits échantillons d'entrée ; et
   - une interpolation polynomiale de type Hermite desdits échantillons d'entrée.

5. Dispositif selon l'une quelconque des revendications 1 à 4 dans lequel :

   - ladite première fonction de transfert $H_1^d(Z^{-1})$ est exprimée dans une base de polynômes en $Z^{-1}$ correspondant à une implémentation selon ladite structure de Newton ; et
   - ladite deuxième fonction de transfert $H_2^d(Z^{-1})$ est exprimée au moins en partie dans ladite base de polynômes en $Z^{-1}$.

6. Dispositif selon l'une quelconque des revendications 1 à 5 dans lequel ledit nombre réel $d$ est compris dans le segment $[-N/2; 1 - N/2[$, l'ordre de ladite interpolation de type Lagrange étant égal à $N - 1$ avec N un entier,

   et dans lequel ladite deuxième fonction de transfert $H_2^d(Z^{-1})$ s'exprime comme :

$$H_2^d(Z^{-1}) = \sum_{n=1}^{N} q_{n,1}(1 - Z^{-1})^{n-1} + \sum_{n=1}^{N}\sum_{m=2}^{N} q_{n,m}\left[(1 - Z^{-1})^{n-1}\prod_{i=0}^{m-2}(d + i)\right]$$

   avec $q_{n,m}$ des éléments d'une matrice $Q$ de N lignes et N colonnes, ladite matrice $Q$ s'exprimant comme un produit de matrices :

$$Q = \left(T_d^T\right)^{-1}PT_z^{-1}$$

**21**

avec :

- $T_d$ une matrice de N lignes et N colonnes transformant un vecteur $\overrightarrow{\mu}$ = [1, $\mu$, $\mu^2$, ..., $\mu^{N-1}$] en un vecteur

$$\vec{d} = [1, d, d(d+1), ..., \prod_{i=0}^{N-2}(d+i)]$$ , avec $\mu$ = d + (N - 1)/2 ;

- $T_z$ une matrice de N lignes et N colonnes transformant un vecteur $\vec{Z}$ = [1, $z^{-1}$, $z^{-2}$, ..., $z^{-(N-1)}$] en un vecteur $\overrightarrow{\nabla Z}$ = [1, (1 - $z^{-1}$), (1 - $z^{-1}$)$^2$, ..., (1 - $z^{-1}$)$^{N-1}$] ;

- $P$ une matrice de Farrow symétrique représentant ladite autre interpolation, ladite matrice $P$ ayant N lignes et N colonnes et représentant une fonction de transfert dans le domaine transformé en Z, $H_2^{\mu}(Z^{-1})$, s'exprimant comme :

$$H_2^{\mu}(Z^{-1}) = \sum_{j=1}^{N} \beta_j(\mu) z^{-(j-1)} = \sum_{j=1}^{N} \left( \sum_{i=1}^{N} p_{i,j}\,\mu^{i-1} \right) z^{-(j-1)}$$

avec $p_{i,j}$ un élément d'indice de ligne i et d'indice de colonne j de ladite matrice $P$, lesdits N polynômes $\beta_j(\mu)$ vérifiant $\beta_j(\mu)$ = +$\beta_{N-j+1}(\mu)$ ou $\beta_j(\mu)$ = -$\beta_{N-j+1}(\mu)$.

7. Dispositif selon la revendication 6 dans lequel ladite matrice $T_d$ s'exprime comme un produit de matrices $T_d = T_d^2 T_d^1$, avec $T_d^1$ et $T_d^2$ deux matrices de N lignes et N colonnes, au moins un élément, $T_d^1[i,j]$, d'indice de ligne i et d'indice de colonne j, de ladite matrice $T_d^1$, étant proportionnel à $\binom{i-1}{j-1}\left(-\frac{N-1}{2}\right)^{i-j}$, avec $\binom{i-1}{j-1}$ un coefficient binomial lu $j$ - 1 parmi $i$ - 1, au moins un élément, $T_d^2[i,j]$, d'indice de ligne i et d'indice de colonne j, de ladite matrice $T_d^2$, étant proportionnel à un nombre de Stirling de première espèce $S_{j-1}^{(i-1)}$.

8. Dispositif selon la revendication 6 ou 7 dans lequel au moins un élément, $T_z[i,j]$, d'indice de ligne i et d'indice de colonne j, de ladite matrice $T_z$, est proportionnel à $\binom{i-1}{j-1}(-1)^{j+1}$ avec $\binom{i-1}{j-1}$ un coefficient binomial lu $j$ - 1 parmi $i$ - 1.

9. Dispositif selon l'une quelconque des revendications 1 à 8 dans lequel ledit nombre réel d ou/et ledit paramètre de combinaison $c$ est/sont variable(s).

10. Dispositif selon l'une quelconque des revendications 1 à 9 comprenant une structure de Newton modifiée (300, 500, 600) comprenant :

- ladite structure de Newton (100) ; et
- au moins une boucle de retour additionnelle (210_1, 210_2, 210_3, 410_1, 410_2, 410_3, 410_4, 610) entre :

- une sortie d'une ligne à retard (110_1, 110_2, 110_3) de ladite structure de Newton ; et
- une sortie de ladite structure de Newton ;

ladite au moins une boucle de retour additionnelle comprenant au moins un bloc multiplieur, un opérande dudit au moins un bloc multiplieur (320_1, 320_2, 520_1, 620) étant proportionnel audit paramètre de combinaison $c$.

11. Dispositif selon la revendication 10 en ce qu'elle dépend de la 3, dans lequel ladite structure de Newton modifiée (300, 500, 600) implémente :

- ladite structure de Newton (100) lorsque ledit paramètre de combinaison $c$ vaut 0 ; et
- ladite structure quasi-Newton (200, 400) lorsque ledit paramètre de combinaison $c$ vaut 1.

**12.** Dispositif selon l'une quelconque des revendications 1 à 8 dans lequel ledit paramètre de combinaison *c* est fixe, ledit filtre comprenant une structure de Newton modifiée (500') comprenant au moins en partie ladite structure de Newton (100).

**13.** Dispositif selon l'une quelconque des revendications 1 à 12, **caractérisé en ce qu'**il est configuré pour obtenir le nombre réel d définissant les instants fractionnaires d'échantillonnage et le au moins un paramètre de combinaison c réel d'un dispositif de pilotage (810, 910).

**14.** Dispositif (750_1, 750_2) de changement de rythme d'échantillonnage comprenant au moins un dispositif numérique selon l'une quelconque des revendications 1 à 13.

**15.** Equipement de réception (700) d'un signal radiofréquence comprenant au moins un dispositif de changement de rythme d'échantillonnage selon la revendication 14.

**Patentansprüche**

**1.** Digitale interpolierende Filtervorrichtung mit fraktionaler Verzögerung für ein Signal $x(t)$, die eine Serie von Ausgangsabtastwerten liefert, die ein Signal $x(t)$ zu Abtastzeitpunkten der Form $(n + d)T_s$ approximieren, auf der Grundlage einer Serie von Eingangsabtastwerten des Signals $x(t)$, die zu Abtastzeitpunkten der Form $nT_s$ genommen wurden, wobei $n$ eine ganze Zahl, $T_s$ eine Abtastperiode und $d$ eine reelle Zahl ist, die die fraktionalen Abtastzeitpunkte definiert,

die Vorrichtung umfasst:

- eine Newton-Struktur, die eine erste Übertragungsfunktion $H_1^d(Z^{-1})$ implementiert, die eine polynomiale Lagrange-Interpolation der Eingangsabtastwerte darstellt, die gemäß einer Newton-Struktur (100) implementiert ist; und
- eine weitere Newton-Struktur, die mindestens die genannte Newton-Struktur umfasst und eine zweite Übertragungsfunktion $H_2^d(Z^{-1})$ implementiert, die eine weitere polynomiale Interpolation der Eingangsabtastwerte darstellt; **dadurch gekennzeichnet, dass** die Vorrichtung außerdem umfasst

eine Übertragungsfunktion des Filters im Z-transformierten Bereich, $H_c^d(Z^{-1})$ die als Linearkombination zwischen der ersten Übertragungsfunktion und der zweiten Übertragungsfunktion ausgedrückt wird und von mindestens einem reellen Kombinationsparameter c abhängig ist.

**2.** Vorrichtung nach Anspruch 1, wobei die Linearkombination der ersten $H_1^d(Z^{-1})$ und zweiten $H_2^d(Z^{-1})$ Übertragungsfunktion wie folgt ausgedrückt wird:

$$H_c^d(Z^{-1}) = H_1^d(Z^{-1}) + c\left(H_2^d(Z^{-1}) - H_1^d(Z^{-1})\right).$$

**3.** Vorrichtung nach Anspruch 1 oder 2, wobei die weitere Struktur eine Quasi-Newton-Struktur (200, 400) ist.

**4.** Vorrichtung nach Anspruch 3, wobei die weitere polynomiale Interpolation der Eingangsabtastwerte zu der Gruppe gehört, die umfasst:

- eine Spline-Polynominterpolation der Eingangsabtastwerte; und
- eine polynomiale Hermite-Interpolation der Eingangsabtastwerte.

**5.** Vorrichtung nach einem der Ansprüche 1 bis 4, wobei:

- die erste Übertragungsfunktion $H_1^d(Z^{-1})$ in einer Basis von Polynomen in $Z^{-1}$ ausgedrückt wird entsprechend einer Implementierung gemäß der Newtonstruktur; und

- die zweite Übertragungsfunktion $H_2^d(Z^{-1})$ zumindest teilweise in der Basis von Polynomen in $Z^{-1}$ ausgedrückt wird.

6. Vorrichtung nach einem der Ansprüche 1 bis 5, wobei die reelle Zahl d innerhalb des Intervals [-$N$/2; 1 - $N$/2[ liegt, wobei die Ordnung der Lagrange-Interpolation gleich $N$ - 1 ist, wobei $N$ eine ganze Zahl ist,

und wobei die zweite Übertragungsfunktion $H_2^d(Z^{-1})$ ausgedrückt wird als:

$$H_2^d(Z^{-1}) = \sum_{n=1}^{N} q_{n,1}(1 - Z^{-1})^{n-1} + \sum_{n=1}^{N}\sum_{m=2}^{N} q_{n,m}\left[(1 - Z^{-1})^{n-1}\prod_{i=0}^{m-2}(d + i)\right]$$

mit Elementen $q_{n,m}$ einer Matrix $Q$ mit N Zeilen und N Spalten, wobei die Matrix $Q$ ausgedrückt wird als ein Produkt der Matrizen :

$$Q = (T_d^T)^{-1}PT_z^{-1}$$

mit:

- $T_d$ einer Matrix aus N Zeilen und N Spalten, die einen Vektor

$\vec{\mu}$= [1, $\mu$, $\mu^2$, ... , $\mu^{N-1}$] in einen Vektor $\vec{d} = \left[1, d, d(d + 1), ... , \prod_{i=0}^{N-2}(d + i)\right]$ transformiert mit $\mu$ = d + ($N$ - 1)/2;
- $T_z$ einer Matrix mit N Zeilen und N Spalten, die einen Vektor $\vec{Z}$ = [1, $z^{-1}$, $z^{-2}$, ... , $z^{-(N-1)}$] in einen Vektor $\vec{\nabla Z}$ = [1, (1 - $z^{-1}$), (1 - $z^{-1}$)$^2$, ... , (1 - $z^{-1}$)$^{N-1}$] transformiert;
- $P$ einer symmetrischen Farrow-Matrix, die die andere Interpolation darstellt, wobei die Matrix $P$ N Zeilen und N Spalten hat und eine Übertragungsfunktion $H_2^\mu(Z^{-1})$ im Z-transformierten Bereich darstellt und ausgedrückt wird als:

$$H_2^\mu(Z^{-1}) = \sum_{j=1}^{N} \beta_j(\mu)z^{-(j-1)} = \sum_{J=1}^{N}\left(\sum_{i=1}^{N} p_{i,j}\mu^{i-1}\right)z^{-(j-1)}$$

mit $p_{i,j}$ einem Element mit Zeilenindex i und Spaltenindex j der Matrix $P$,
wobei die N Polynome $\beta_j(\mu)..\beta_j(\mu)$ = +$\beta_{N-j+1}(\mu)$ oder $\beta_j(\mu)$ = -$\beta_{N-j+1}(\mu)$ erfüllen.

7. Vorrichtung nach Anspruch 6, wobei die Matrix $T_d$ ausgedrückt wird als ein Matrixprodukt $T_d = T_d^2 T_d^1$ , mit zwei Matrizen $T_d^1$ und $T_d^2$ mit N Zeilen und N Spalten, mindestens einem Element $T_d^1[i,j]$ mit Zeilenindex i und Spaltenindex j der Matrix $T_d^1$, die proportional ist zu $\binom{i-1}{j-1}\left(-\frac{N-1}{2}\right)^{i-j}$ mit einem Binomialkoeffizienten $\binom{i-1}{j-1}$ gelesen als $j$ - 1 unter $i$ - 1,

mindestens ein Element $T_d^2[i,j]$ mit Zeilenindex i und Spaltenindex j der Matrix $T_d^2$ , die proportional ist zu einer Stirlingzahl der ersten Art $S_{j-1}^{(i-1)}$ .

8. Vorrichtung nach Anspruch 6 oder 7, bei der mindestens ein Element $T_z[i,j]$ mit Zeilenindex i und Spaltenindex j der Matrix $T_z$ proportional ist zu $\binom{i-1}{j-1}(-1)^{j+1}$ mit einem Binomialkoeffizienten $\binom{i-1}{j-1}$ gelesen als $j$ - 1 unter $i$ - 1.

9. Vorrichtung nach einem der Ansprüche 1 bis 8, wobei die reelle Zahl $d$ oder/und der Kombinationsparameter $c$ variabel ist/sind.

**10.** Vorrichtung nach einem der Ansprüche 1 bis 9 mit einer modifizierten Newton-Struktur (300, 500, 600), umfassend:

- die Newton-Struktur (100); und
- mindestens eine zusätzliche Rückkopplungsschleife (210_1, 210_2, 210_3, 410_1, 410_2, 410_3, 410_4, 610) zwischen:

- einem Ausgang einer Verzögerungsleitung (110_1, 110_2, 110_3) der Newton-Struktur; und
- einem Ausgang der Newton-Struktur;

wobei die mindestens eine zusätzliche Rückkopplungsschleife mindestens einen Multipliziererblock umfasst, wobei ein Operand des mindestens einen Multipliziererblocks (320_1, 320_2, 520_1, 620) proportional zu dem Kombinationsparameter $c$ ist.

**11.** Vorrichtung nach Anspruch 10, insofern sie von 3 abhängt, wobei die modifizierte Newton-Struktur (300, 500, 600) implementiert:

- die Newton-Struktur (100), wenn der Kombinationsparameter $c$ den Wert 0 hat; und
- die Quasi-Newton-Struktur (200, 400), wenn der Kombinationsparameter $c$ den Wert 1 hat.

**12.** Vorrichtung nach einem der Ansprüche 1 bis 8, wobei der Kombinationsparameter $c$ fest ist, wobei der Filter eine modifizierte Newton-Struktur (500') umfasst, die zumindest teilweise die Newton-Struktur (100) umfasst.

**13.** Vorrichtung nach einem der Ansprüche 1 bis 12, **dadurch gekennzeichnet, dass** sie so konfiguriert ist, um die reelle Zahl $d$, die die fraktionalen Abtastzeitpunkte definiert, und den mindestens einen reellen Kombinationsparameter $c$ von einem Steuergerät (810, 910) erhält.

**14.** Vorrichtung (750_1, 750_2) zur Änderung der Abtastrate mit mindestens einer digitalen Vorrichtung nach einem der Ansprüche 1 bis 13.

**15.** Empfangsgerät (700) für ein Hochfrequenzsignal mit mindestens einer Vorrichtung zur Änderung der Abtastrate nach Anspruch 14.

**Claims**

**1.** A digital interpolator filtering device with fractional delay of a signal x(t) delivering a series of output samples approximating a signal x(t) at sampling times of the form (n+d) $T_s$ on the basis of a series of input samples of said signal x(t) taken at sampling times of the form $nT_s$, with n an integer, $T_s$ a sampling period and d a real number defining the fractional sampling times, said device comprises:

- a Newton structure implementing a first transfer function $H_1^d(Z^{-1})$ representing a Lagrange-type polynomial interpolation of said input samples implemented according to a Newton structure (100); and
- another Newton structure comprising at least said Newton structure and implementing a second transfer function $H_2^d(Z^{-1})$ representing another polynomial interpolation of said input samples; **characterised in that** said device further comprises a function for transferring said filter in the Z transformed domain, $H_c^d(Z^{-1})$ expressed as a linear combination between the first transfer function and the second transfer function and being a function of at least one real parameter of combination c.

**2.** The device according to claim 1 wherein said linear combination of said first $H_1^d(Z^{-1})$ and second $H_2^d(Z^{-1})$ transfer functions is expressed as:

$$H_c^d(Z^{-1}) = H_1^d(Z^{-1}) + c\left(H_2^d(Z^{-1}) - H_1^d(Z^{-1})\right)$$

3. The device according to claim 1 or 2 wherein said other structure is a quasi-Newton structure (200, 400).

4. The device according to claim 3 wherein said other polynomial interpolation of said input samples belongs to the group comprising:

    - a Spline type polynomial interpolation of said input samples; and
    - a Hermite type polynomial interpolation of said input samples.

5. The device according to any one of claims 1 to 4 wherein:

    - said first transfer function $H_1^d(Z^{-1})$ is expressed in a base of $Z^{-1}$ polynomials corresponding to an implementation according to said Newton structure; and
    - said second transfer function $H_2^d(Z^{-1})$ is expressed at least in part in said base of $Z^{-1}$ polynomials.

6. The device according to any one of claims 1 to 5 wherein said real number d is comprised in the segment [-N/2; 1-N/2[, the order of said Lagrange type interpolation being equal to N-1 with N an integer,

and wherein said second transfer function $H_2^d(Z^{-1})$ is expressed as:

$$H_2^d(Z^{-1}) = \sum_{n=1}^{N} q_{n,1}(1 - Z^{-1})^{n-1} + \sum_{n=1}^{N}\sum_{m=2}^{N} q_{n,m}\left[(1 - Z^{-1})^{n-1}\prod_{i=0}^{m-2}(d + i)\right]$$

with $q_{n,m}$ elements of a matrix Q of N rows and N columns, said matrix Q being expressed as a product of matrices:

$$Q = \left(T_d^T\right)^{-1} P T_z^{-1}$$

with:

    - $T_d$ a matrix of N rows and N columns transforming a vector $\vec{\mu}$ = [1, $\mu$, $\mu^2$, ..., $\mu^{N-1}$] into a vector $\vec{d}$ = [1, d,

    $d(d + 1), ..., \prod_{i=0}^{N-2}(d + i)]$ , with $\mu$ = d+(N-1)/2;
    - $T_z$ a matrix of N rows and N columns transforming a vector $\vec{z}$ = [1, $z^{-1}$, $z^2$, ..., $z^{-(N-1)}$] into a vector $\vec{\nabla Z}$ = [1, (1 - $z^{-1}$), (1 - $z^{-1}$)$^2$, ..., (1 - $z^{-1}$)$^{N-1}$] ;
    - P a symmetric Farrow matrix representing said other interpolation,

said matrix P having N rows and N columns and representing a transfer function in the Z transformed domain, $H_2^\mu(Z^{-1})$ , expressed as:

$$H_2^\mu(Z^{-1}) = \sum_{j=1}^{N} \beta_j(\mu)z^{-(j-1)} = \sum_{j=1}^{N}\left(\sum_{i=1}^{N} p_{i,j}\mu^{i-1}\right)z^{-(j-1)}$$

with $p_{i,j}$, an element with row index i and column index j of said matrix P,
said N polynomials $\beta_j(\mu)$ verifying $\beta_j(\mu)$ = +$\beta_{N-j+1}(\mu)$ or $\beta_j(\mu)$ = -$\beta_{N-j+1}(\mu)$.

7. The device according to claim 6 wherein said matrix $T_d$ is expressed as a product of matrices $T_d = T_d^2 T_d^1$ , with $T_d^1$ and $T_d^2$ two matrices of N rows and N columns, at least one element, $T_d^1[i,j]$ , of row index i and column index j, of said matrix $T_d^1$ , being proportional to $\binom{i-1}{j-1}\left(-\frac{N-1}{2}\right)^{i-j}$ , with $\binom{i-1}{j-1}$ a binomial coefficient

read j-1 among i-1,

at least one element, $T_d^2[i,j]$, with row index i and column index j, of said matrix $T_d^2$, being proportional to a Stirling number of the first kind $S_{j-1}^{(i-1)}$.

8. The device according to claim 6 or 7 wherein at least one element, $T_z[i,j]$, with row index i and column index j, of said matrix $T_z$, is proportional to $\binom{i-1}{j-1}(-1)^{j+1}$ with $\binom{i-1}{j-1}$ a binomial coefficient read j-1 among i-1.

9. The device according to any one of claims 1 to 8 wherein said real number d and/or said combination parameter c is/are variable.

10. The device according to any one of claims 1 to 9 comprising a modified Newton structure (300, 500, 600) comprising:

  - said Newton structure (100); and
  - at least one additional feedback loop (210_1, 210_2, 210_3, 410_1, 410_2, 410_3, 410_4, 610) between:
  - an output of a delay line (110_1, 110_2, 110_3) of said Newton structure; and
  - an output of said Newton structure;

  said at least one additional feedback loop comprising at least one multiplier block, an operand of said at least one multiplier block (320_1, 320_2, 520_1, 620) being proportional to said combination parameter c.

11. The device according to claim 10 in that it depends on 3, wherein said modified Newton structure (300, 500, 600) implements:

  - said Newton structure (100) when said combination parameter c is 0; and
  - said quasi-Newton structure (200,400) when said combination parameter c is equal to 1.

12. The device according to any one of claims 1 to 8 wherein said combination parameter c is fixed,
said filter comprising a modified Newton structure (500') comprising at least in part said Newton structure (100) .

13. The device according to any one of claims 1 to 12, **characterised in that** it is configured to obtain the real number d defining the fractional sampling times and the at least one real parameter of combination c of a control device (810, 910).

14. The device (750_1, 750_2) for changing the sampling rate comprising at least one digital device according to any one of claims 1 to 13.

15. Equipment for receiving (700) a radio frequency signal comprising at least one device for changing the sampling rate according to claim 14.

**Figure 1**

**Figure 2**

**Figure 3a**

**Figure 3b**

400

100

$1$ 110_1 $1/2$ 110_2 $1/3$ 110_3

$1-z^{-1}$ $1-z^{-1}$ $1-z^{-1}$

$2$

$d$ $d+1$ $d+2$

410_4 410_3 410_2 410_1

$2$ $3/2$

**Figure 4**

500

100

$1$ 110_1 $1/2$ 110_2 $1/3$ 110_3

$1-z^{-1}$ $1-z^{-1}$ $1-z^{-1}$

520_1

$2c$

$d$ $d+1$ $d+2$

410_4 410_3 410_2 410_1

$2$ $3/2$

**Figure 5a**

**Figure 5b**

**Figure 5c**

Figure 6a

**Figure 6b**

**Figure 7a**

**Figure 7b**

$C = 0$

**Figure 7c**

$C = 1$

810

810p

*x(nTs)*

"c"

"d"

800

μP

810m

*x((n+d)Ts)*

**Figure 8**

910

910f

910c

910p

910m

FFT

CTRL

μP

910m

"c"

*x(nTs)*

900

*x((n+d)Ts)*

**Figure 9**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **FARROW, C. W.** A continuously variable digital delay element Circuits and Systems. *IEEE International Symposium on,* 1988, vol. 3, 2641-2645
- **VALIMAKI, V.** A new filter implémentation strategy for Lagrange interpolation. *Circuits and Systems, 1995. ISCAS '95., 1995 IEEE International Symposium on, Seattle, WA,* 1995, vol. 1, 361-364
- **TASSART, S. ; DEPALLE, P.** Fractional delay lines using Lagrange interpolation. *Proceedings of the 1996 International Computer Music Conférence, Hong Kong,* Avril 1996, 341-343
- **LAMB, D. ; CHAMON, L. ; NASCIMENTO, V.** Efficient filtering structure for spline interpolation and decimation. *Electronics Letters, IET,* 2015, vol. 52, 39-41
- **SOONTORNWONG, P. ; CHIVAPREECHA, S. ; PRADABPET, C.** A Cubic Hermite variable fractional delay filter Intelligent Signal Processing and Communications Systems. *2011 International Symposium on,* 2011, 1-4
- **HUNTER, M. T.** Design of Polynomial-based Filters for Continuously Variable Sample Rate Conversion with Applications in Synthetic Instrumentation and Software Defined Radio. University of Central Florida Orlando, 2008